(19)

Europäisches Patentamt

European Patent Office

Office européen des brevets

(11) **EP 4 683 257 A1**

(12) **EUROPEAN PATENT APPLICATION**
published in accordance with Art. 153(4) EPC

(43) Date of publication:
**21.01.2026 Bulletin 2026/04**

(21) Application number: **24796457.0**

(22) Date of filing: **09.01.2024**

(51) International Patent Classification (IPC):
*H04L 1/1825* (2023.01)          *H03M 13/37* (2006.01)
*H04L 1/00* (2006.01)          *H04L 1/1607* (2023.01)
*H04W 52/46* (2009.01)

(52) Cooperative Patent Classification (CPC):
**H03M 13/37; H04L 1/00; H04L 1/1607;
H04L 1/1825; H04W 52/46**

(86) International application number:
**PCT/JP2024/000112**

(87) International publication number:
**WO 2024/224697 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.04.2023 PCT/JP2023/016067**

(71) Applicant: **MITSUBISHI ELECTRIC
CORPORATION
Chiyoda-ku
Tokyo 100-8310 (JP)**

(72) Inventors:
• **SUMI, Takenori
  Tokyo 100-8310 (JP)**
• **NAGAI, Yukimasa
  Tokyo 100-8310 (JP)**

(74) Representative: **Pfenning, Meinig & Partner mbB
Patent- und Rechtsanwälte
Theresienhöhe 11a
80339 München (DE)**

(54) **CONTENT DISTRIBUTION SYSTEM, CONTENT DISTRIBUTION METHOD, AND CONTENT
DISTRIBUTION PROGRAM**

(57)     A subject distribution apparatus, which is a content distribution apparatus, includes a transmission unit (121). The transmission unit (121) transmits $K_2$ pieces of blocks selected from among $K_1$ pieces of encoded blocks (132) and M pieces of redundant data blocks (133) based on erasure correction coding, together with a transmission source identifier, as wireless signals. Further, when a destination identifier indicated in a reception response received from each content distribution apparatus is consistent with an apparatus identifier of the subject distribution apparatus, the transmission unit (121) transmits $K_2$-$R_{min}$ pieces of blocks selected from among blocks that have not been transmitted among the $K_1$ pieces of encoded blocks (132) and the M pieces of redundant data blocks (133), as wireless signals, where the relatively small number of blocks among the number of blocks that have succeeded to be received as indicated in each received reception response is denoted as $R_{min}$.

Fig. 2

## Description

## Technical Field

The present disclosure relates to a content distribution system, a content distribution method, and a content distribution program.

## Background Art

There are two possible methods of distributing content via wireless communication: a method in which a transmission station distributes content to each reception station individually using unicast; and a method in which a transmission station distributes content to a plurality of reception stations simultaneously using multicast.

When content is distributed using unicast, the time taken to distribute the content to all reception stations increases as the number of reception stations increases. On the other hand, when content is distributed using multicast, the content can be distributed all at once, regardless of the number of reception stations.

Therefore, when content is distributed using wireless communication, using multicast to distribute the content is an efficient method.

However, in wireless communication, a reception error due to fluctuations in the received electric power, a reception error due to interference signals from other systems, or the like may occur. Therefore, it is not possible to distribute all the content correctly in a single transmission. Therefore, when a reception error occurs in cases where loss of content data is unacceptable, such as during the firmware distribution to an Internet of Things (IoT) terminal, it is necessary to retransmit data corresponding to the occurrence point of the reception error.

Furthermore, since the occurrence point of the reception error varies depending on the reception station, in cases where all the content is distributed correctly, it is necessary to retransmit data that differs for each reception station, as data corresponding to the occurrence point of the reception error. Therefore, in the method of distributing content using multicast, as the number of reception stations increases, the efficiency of content distribution declines because the amount of data that needs to be retransmit increases.

Patent Literature 1 discloses a method in which when content data is distributed using a wireless Local Area Network (LAN), the amount of data to be transmitted is reduced by applying an erasure correction code to the content data to be distributed. In Patent Literature 1, an encoding method described in Non-Patent Literature 1 is mentioned as an example of the erasure correction code.

When the erasure correction code is used, redundant data for restoring data loss is generated by dividing the original content data to be transmitted into a plurality of encoded blocks of fixed length, and executing encoding to the plurality of encoded blocks. When erasure correction coding is executed at a coding rate of 1/3 on 180 pieces of encoded blocks, each with a data length of 1,500 bytes, 360 pieces of redundant data blocks, each with a data length of 1,500 bytes, are generated, as a specific example. At the reception station, if it is possible to receive 180 or more pieces of data blocks out of a total of 540 pieces of data blocks, which is the sum of the number of original encoded blocks and the number of redundant data blocks, the content data can be decoded.

## Citation List

## Patent Literature

[Patent Literature 1] JP 6556415 B1

## Non-Patent Literature

[Non-Patent Literature 1] W. Matsumoto et al., "Rate-Compatible QC-LDPC codes", SITA2006, Nov.28-Dec.1, 2006.

## Summary of Invention

## Technical Problem

The method disclosed in Patent Literature 1 assumes a network that connects in a star-shaped manner, such as a wireless LAN.

Here, a case is considered in which this method is applied to a multi hop network. In this case, there is a reception station that cannot directly communicate with the transmission station. Therefore, if additional transmissions are required to the transmission station in the event of decode failure, communication efficiency deteriorates. Further, in this case, it is necessary for the reception station that has received the encoded blocks and the redundant data blocks to transfer the received data to the reception station at the next hop. However, if all reception stations transfer data, the number of packets increases. Therefore, there is a problem in that packet collisions, an increase in electric power consumption, and the like occur.

The objective of the present disclosure is to improve communication efficiency when content distribution is executed using an erasure correction code in a multi hop network.

## Solution to Problem

A content distribution system according to the present disclosure including a plurality of content distribution apparatuses, each of which distributes content data via wireless communication,

at a time when each content distribution apparatus of the plurality of content distribution apparatuses is a subject distribution apparatus, the subject distribution apparatus includes:

an encoding processing unit to divide subject content data, which is content data, into $K_1$ pieces of encoded blocks, and to generate M pieces of redundant data blocks by executing erasure correction coding on the $K_1$ pieces of encoded blocks;

a transmission unit to transmit $K_2$ pieces of blocks selected from among the $K_1$ pieces of encoded blocks and the M pieces of redundant data blocks, together with a transmission source identifier, which is an apparatus identifier of the subject distribution apparatus, as wireless signals; and

a reception unit to receive a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, wherein the transmission unit of the subject distribution apparatus, when the destination identifier indicated in the reception response received by the subject distribution apparatus is consistent with the apparatus identifier of the subject distribution apparatus, transmits $K_2$-$R_{min}$ pieces of blocks selected from among blocks that have not been transmitted among the $K_1$ pieces of encoded blocks and the M pieces of redundant data blocks, as wireless signals, where the relatively small number of blocks among the number of blocks that have succeeded to be received as indicated in each reception response received by the subject distribution apparatus is denoted as $R_{min}$.

**Advantageous Effects of Invention**

According to the present disclosure, when the destination identifier indicated in the reception response is consistent with the apparatus identifier of the subject distribution apparatus, the transmission unit of the subject distribution apparatus transmits $K_2$-$R_{min}$ pieces of blocks that have not been transmitted, as wireless signals. Therefore, according to the present disclosure, as the number of transmissions of reception responses is reduced, it is possible to improve communication efficiency when content distribution is executed using an erasure correction code in a multi hop network.

**Brief Description of Drawings**

Fig. 1 is a diagram illustrating an example of a configuration of a content distribution system 90 according to Embodiment 1.

Fig. 2 is a diagram illustrating an example of a configuration of a data transmission apparatus 100 according to Embodiment 1.

Fig. 3 is a diagram illustrating an example of a configuration of a data reception apparatus 200 according to Embodiment 1.

Fig. 4 is a flowchart illustrating operation of the data transmission apparatus 100 according to Embodiment 1.

Fig. 5 is a diagram that describes the format of an encoded block 132 or a redundant data block 133 according to Embodiment 1.

Fig. 6 is a diagram that describes the format of a reception response according to Embodiment 1.

Fig. 7 is a flowchart illustrating operation of the data reception apparatus 200 according to Embodiment 1.

Fig. 8 is a flowchart illustrating the operation of the data reception apparatus 200 according to Embodiment 1.

Fig. 9 is a diagram illustrating an example of a hardware configuration of the data transmission apparatus 100 according to a modification of Embodiment 1.

Fig. 10 is a diagram illustrating an example of a configuration of a data reception apparatus 200B according to Embodiment 2.

Fig. 11 is a flowchart illustrating operation of the data reception apparatus 200B according to Embodiment 2.

Fig. 12 is a flowchart illustrating the operation of the data reception apparatus 200B according to Embodiment 2.

Fig. 13 is a diagram illustrating an example of a configuration of a data reception apparatus 200C according to Embodiment 3.

Fig. 14 is a flowchart illustrating operation of the data reception apparatus 200C according to Embodiment 3.

Fig. 15 is a flowchart illustrating the operation of the data reception apparatus 200C according to Embodiment 3.

Fig. 16 is a diagram that describes the format of the reception response according to Embodiment 4.

Fig. 17 is a flowchart illustrating the operation of the data transmission apparatus 100 according to Embodiment 5.

Fig. 18 is a diagram illustrating an example of a configuration of a data transmission apparatus 100B according to Embodiment 6.

Fig. 19 is a diagram illustrating an example of a configuration of a data reception apparatus 200D according to Embodiment 6.

Fig. 20 is a flowchart illustrating operation of the data transmission apparatus 100B according to Embodiment 6.

Fig. 21 is a diagram that describes a generation procedure for additional transmission data according to Embodiment 6 in which (a) is a table illustrating the reception status of the encoded block 132, (b) is a table illustrating the selected encoded block 132, and (c) is a table illustrating the selected encoded block 132.

Fig. 22 is a diagram that describes the format of the additional transmission data according to Embodiment 6.

**Description of Embodiments**

In the description and drawings of embodiments, the same elements and corresponding elements are denoted by the same reference sign. The description of elements denoted by the same reference sign will be omitted or simplified as appropriate. Arrows in the drawings mainly indicate flows of data or flows of processing. Further, "unit" may be appropriately interpreted as "circuit", "step", "procedure", "process", or "circuitry".

Embodiment 1.

Hereinafter, details of the present embodiment will be described with reference to the drawings.

*** Description of Configuration ***

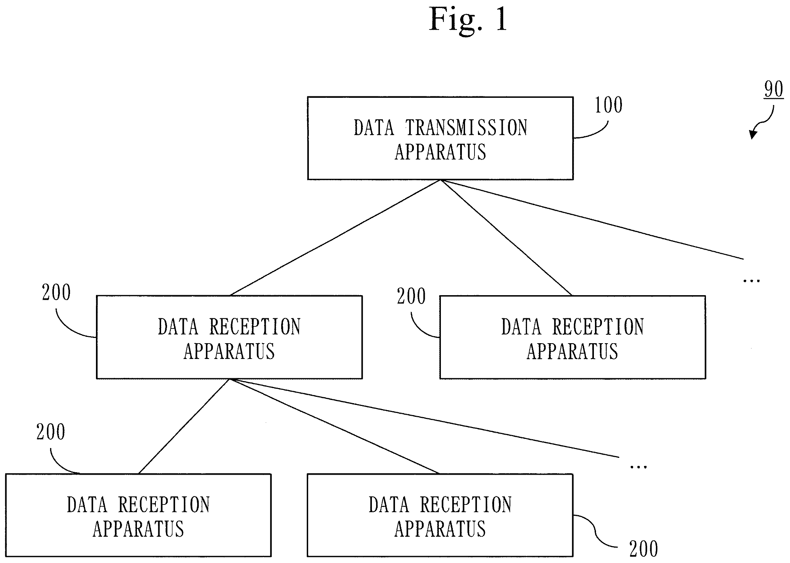

Fig. 1 is a diagram illustrating an example of a configuration of a content distribution system 90. The content distribution system 90 includes one data transmission apparatus 100 and a plurality of data reception apparatuses 200. The data transmission apparatus 100 and the data reception apparatuses 200 are collectively referred to as a content distribution apparatus. The data transmission apparatus 100 is also referred to as a distribution data transmission apparatus. The data reception apparatus 200 is also referred to as a distribution data reception terminal. The content distribution system 90 includes a plurality of content distribution apparatuses, each of which distributes content data via wireless communication. One or more of the content distribution apparatuses included in the content distribution system 90 may not distribute the content data.

The data transmission apparatus 100 is connected wirelessly communicative to the plurality of data reception apparatuses 200.

Each of the data reception apparatuses 200 may also be connected wirelessly communicative to one or more data reception apparatuses 200.

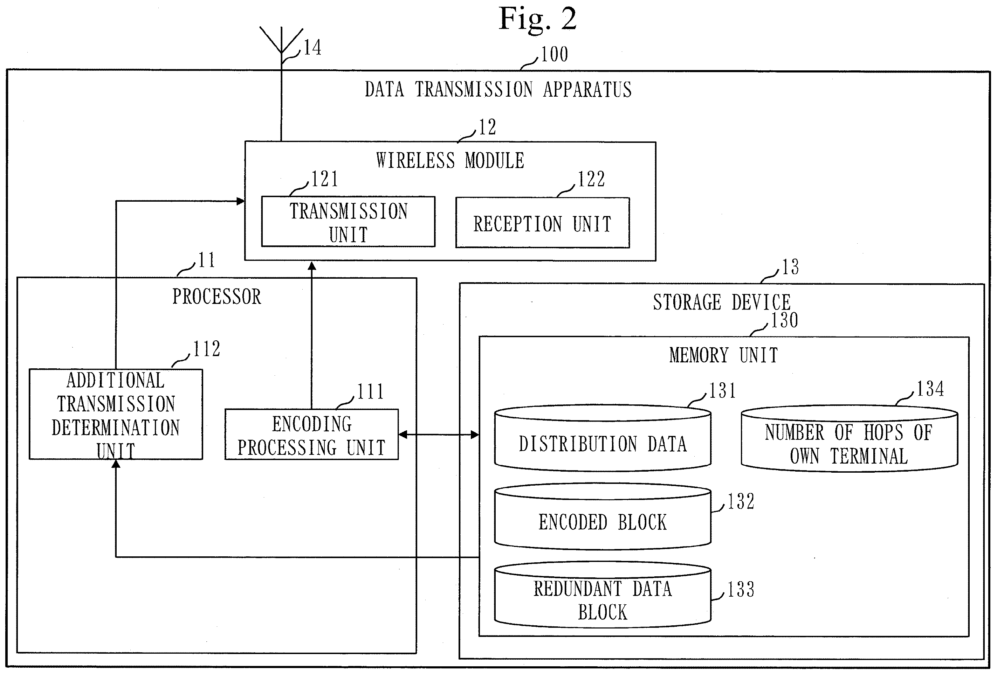

Fig. 2 is a diagram illustrating an example of a configuration of the data transmission apparatus 100 according to the present embodiment. The data transmission apparatus 100 is a computer that includes pieces of hardware such as a processor 11, a storage device 13, a wireless module 12, and an antenna 14. The processor 11 is connected to other hardware via signal lines and controls these pieces of hardware.

Further, the data transmission apparatus 100 includes an encoding processing unit 111, an additional transmission determination unit 112, a transmission unit 121, a reception unit 122, and a memory unit 130, as functional components.

The processor 11 is an Integrated Circuit (IC) that executes processing. A specific example of the processor 11 is a Central Processing Unit (CPU).

The storage device 13 is composed of an auxiliary storage device and a memory.

A specific example of the auxiliary storage device is a Read Only Memory (ROM), a flash memory, or a Hard Disk Drive (HDD). A specific example of the memory is a Random Access Memory (RAM).

The memory unit 130 is implemented by the storage device 13. The memory unit 130 is typically implemented by the memory, but the memory unit 130 may be implemented by both the auxiliary storage device and the memory.

Further, the storage device 13 stores a content distribution program. The content distribution program is a program that causes a computer to implement a function of each unit included in the content distribution apparatus. The content distribution program is executed by the processor 11. The function of each unit of the content distribution apparatus is implemented by software. Data used to execute the content distribution program, data obtained by executing the content distribution program, and the like are appropriately stored in the storage device 13. Each unit of the content distribution apparatus appropriately uses the storage device 13.

The content distribution program may be recorded in a computer readable non-volatile recording medium. A specific example of the non-volatile recording medium is an optical disc or a flash memory. The content distribution program may be provided as a program product.

The wireless module 12 transmits and receives wireless signals via the antenna 14.

The encoding processing unit 111 generates a redundant data block 133 by executing erasure correction coding on an encoded block 132.

The encoding processing unit 111 divides subject content data which is the content data into $K_1$ pieces of encoded blocks 132, and generates M pieces of redundant data blocks 133 by executing the erasure correction coding on the $K_1$ pieces of encoded blocks 132, as a specific example. The encoding processing unit 111 of a subject distribution apparatus may use decode content data to be described below, as the subject content data. Each of $K_1$ and M is a positive integer.

The additional transmission determination unit 112 determines whether or not to transmit each block additionally.

The transmission unit 121 transmits wireless signals to other content distribution apparatuses.

The transmission unit 121 of the subject distribution apparatus transmits $K_2$ pieces of blocks selected from among the $K_1$ pieces of encoded blocks and the M pieces of redundant data blocks, as wireless signals, together with a transmission source identifier which is an apparatus identifier of the subject distribution apparatus, as a specific example. The subject distribution apparatus is each content distribution apparatus of the plurality of content distribution apparatuses. Further, when a destination identifier indicated in a reception response received by the subject distribution apparatus is consistent with the apparatus identifier of the subject distribution apparatus, the transmission unit 121 of the subject distribution apparatus transmits $K_2$-$R_{min}$ pieces of blocks selected from among blocks that have not been transmitted among the $K_1$ pieces of encoded blocks 132 and the M pieces of redundant data blocks 133, as wireless signals. $R_{min}$ is the relatively small number of blocks among the number of blocks that have succeeded to be received as indicated in each reception response received by the subject distribution apparatus. $R_{min}$ may also be the minimum number of blocks among the number of blocks that have succeeded to be received as indicated in each reception response received by the subject distribution apparatus. After a reception response transmission timer has elapsed, the transmission unit 121 of the subject distribution apparatus transmits the reception response indicating the transmission source identifier corresponding to the relatively large number of receptions $R_n$ among the number of receptions $R_n$ of blocks received from each content distribution apparatus by the subject distribution apparatus, among transmission source identifies included in transmission source information, as the destination identifier, via wireless communication. Each of $K_2$, $R_{min}$ and $R_n$ is a positive integer.

The reception unit 122 receives wireless signals from other content distribution apparatuses.

The reception unit 122 of the subject distribution apparatus receives a reception response from each content distribution apparatus of two or more content distribution apparatuses other than the subject distribution apparatus, as a specific example. The reception response is information transmitted by each content distribution apparatus, and is information indicating each of the transmission source identifiers indicating the content distribution apparatus that is the transmission source of the reception response, the destination identifier indicating the content distribution apparatus that is the destination of the reception response, the success or failure of reception for each block at the transmission source, and an identifier of each block received at the transmission source. Further, the reception unit 122 of the subject distribution apparatus receives a block from a content distribution apparatus other than the subject distribution apparatus.

The memory unit 130 stores distribution data 131, the encoded block 132, the redundant data block 133, and the number of hops of own terminal 134.

The distribution data 131 is the content data subject to distribution.

The encoded block 132 is data indicating blocks generated by dividing the distribution data 131.

The redundant data block 133 is data indicating blocks generated by executing the erasure correction coding on the encoded block 132.

The number of hops of own terminal 134 is the number of hops corresponding to the content distribution apparatus that stores the number of hops of own terminal 134, and is data indicating the number of hops from the data transmission apparatus 100.

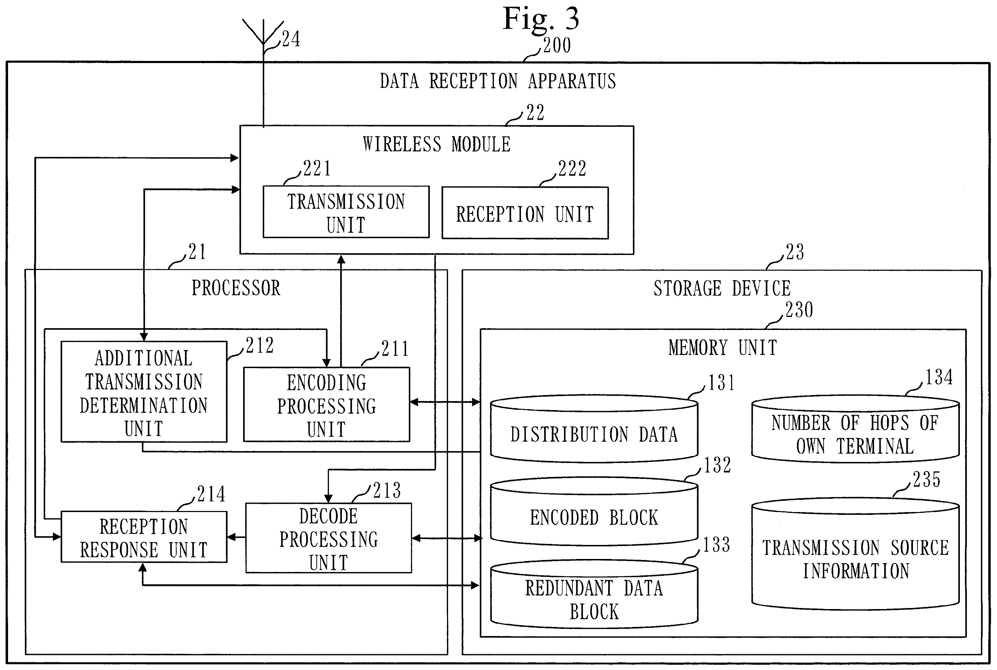

Fig. 3 is a diagram illustrating an example of a configuration of the data reception apparatus 200 according to the present embodiment. The data reception apparatus 200 includes pieces of hardware such as a processor 21, a storage device 23, a wireless module 22, and an antenna 24.

Further, the data reception apparatus 200 includes an encoding processing unit 211, an additional transmission determination unit 212, a decode processing unit 213, a reception response unit 214, a transmission unit 221, a reception unit 222, and a memory unit 230, as functional components.

The processor 21 is the same as the processor 11.

The storage device 23 is the same as the storage device 13.

The wireless module 22 is the same as the wireless module 12.

The antenna 24 is the same as the antenna 14.

The encoding processing unit 211 is the same as the encoding processing unit 111.

The additional transmission determination unit 212 is the same as the additional transmission determination unit 112.

The transmission unit 221 is the same as the transmission unit 121.

The reception unit 222 is the same as the reception unit 122.

The memory unit 230 is the same as the memory unit 130 except for the fact that the memory unit 230 stores transmission source information 235.

The transmission source information 235 is information relating to the transmission source of a received block, and is information indicating the transmission source identifier corresponding to each block received by the subject distribution apparatus.

The decode processing unit 213 of the subject distribution apparatus decodes the content data into decoded content data using the blocks received by the subject distribution apparatus.

The reception response unit 214 manages the reception response and the reception response transmission timer.

When the number of blocks indicated in the reception response received by the subject distribution apparatus as a subject reception response is less than the number of blocks received by the subject distribution apparatus, and when the destination identifier indicated in the subject reception response is consistent with any of transmission source identifiers corresponding to the blocks received by the subject distribution apparatus, the reception response unit 214 extends the reception response transmission timer, as a specific example.

*** Description of Operation ***

An operation procedure of each apparatus included in the content distribution system 90 is equivalent to a content distribution method. Further, a program that implements operation of each apparatus included in the content distribution system 90 is equivalent to the content distribution program.

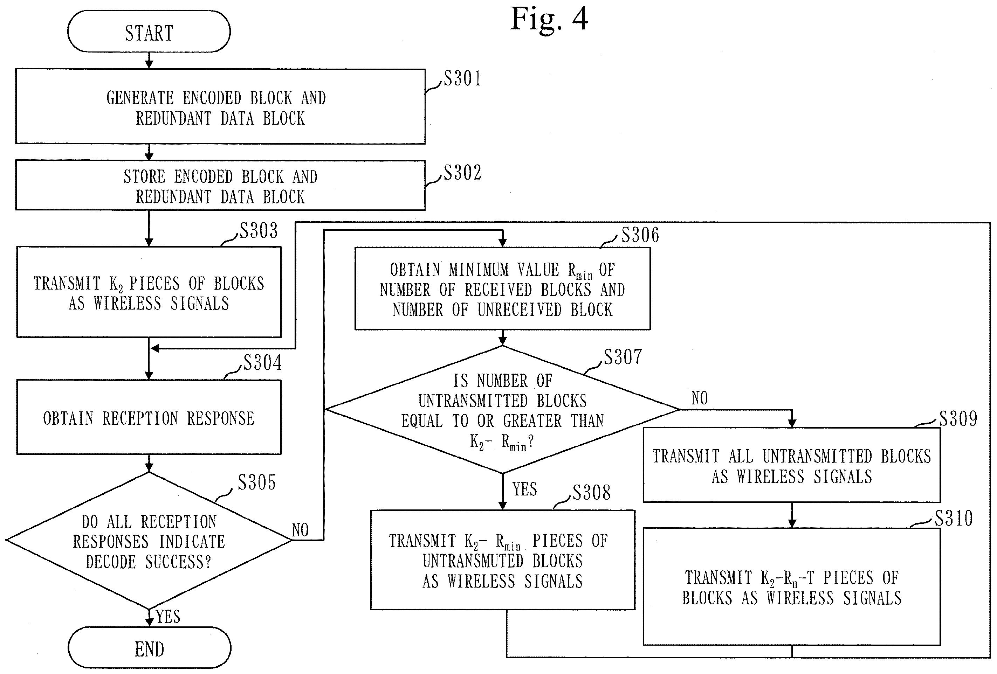

Fig. 4 is a flowchart illustrating an example of operation of the data transmission apparatus 100. The operation of the data transmission apparatus 100 will be described with reference to Fig. 4.

(Step S301)

First, the encoding processing unit 111 obtains the distribution data 131 from the memory unit 130, and divides the obtained distribution data 131 into the $K_1$ pieces of encoded blocks 132.

Next, the encoding processing unit 111 generates the M pieces of redundant data blocks 133 by executing the erasure correction coding on the divided $K_1$ pieces of encoded blocks 132. Here, the value of M varies depending on the encoding rate of the encoding method used. When the encoding rate is 1/3, the value of M is twice the value of $K_1$, as a specific example. Further, the data size of the distribution data 131 to be obtained from the memory unit 130 is the data size of the $K_1$ pieces of encoded blocks 132.

When the total data size of the distribution data 131 stored in the memory unit 130 exceeds the data size of the distribution data 131 that can be obtained by the encoding processing unit 111, the data transmission apparatus 100 repeatedly executes the processing of the present flowchart until all the distribution data 131 stored in the memory unit 130 is distributed.

(Step S302)

The encoding processing unit 111 stores the $K_1$ pieces of encoded blocks 132 and the M pieces of redundant data blocks 133 generated in step S301 into the memory unit 130. At this time, in the memory unit 130, each of the encoded blocks 132 and each of the redundant data blocks 133 are associated with information indicating that they have not been transmitted. The total number of pieces of data of the encoded blocks 132 and the redundant data blocks 133 is $K_1 + M$.

(Step S303)

First, the encoding processing unit 111 selects $K_2$ pieces of blocks from among the encoded blocks 132 and the redundant data blocks 133 stored in step S302. In order to transmit the selected $K_2$ pieces of blocks as wireless signals, the encoding processing unit 111 notifies the transmission unit 121 of the selected $K_2$ pieces of blocks. After that, the transmission unit 121 transmits the notified $K_2$ pieces of blocks as wireless signals. Here, the encoded block 132 and the redundant data block 133 are collectively referred to as a block. The value of $K_2$ is equal to or greater than the value of $K_1$ and less than or equal to the value of M. Further, the $K_2$ pieces of blocks may consist entirely of either encoded blocks 132 or redundant data blocks 133.

Next, in the memory unit 130, the encoding processing unit 111 associates each block of the selected $K_2$ pieces of blocks with information indicating that each block has been transmitted. When the number of occurrences of reception errors is low, the number of transmissions of unnecessary blocks can be reduced by setting the value of $K_2$ close to the value of $K_1$.

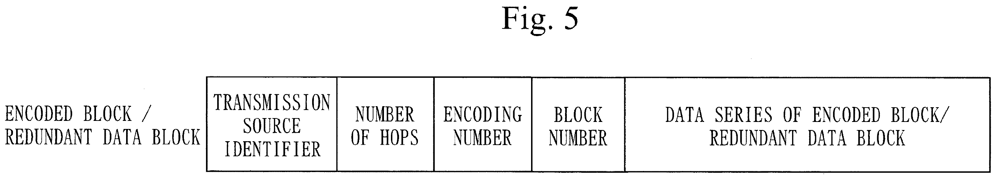

Fig. 5 illustrates an example of the transmission format of a block that the transmission unit 121 transmits. The transmission format of the block includes each of a transmission source identifier, the number of hops, an encoding number, a block number, and data series of either the encoded block 132 or the redundant data block 133, as illustrated in Fig. 5.

The transmission source identifier is information indicating an identifier of an apparatus that transmits data, and is information indicating, as a specific example, an Internet Protocol (IP) address or a Media Access Control (MAC) address.

The number of hops is information indicating how many hops the apparatus that transmits data is from the data transmission apparatus 100. The value that is stored as the number of hops of own terminal 134 in the memory unit 130 is set as the number of hops. The number of hops is 0 in the data transmission apparatus 100.

The encoding number is a sequential number of encoding processes executed in step S301.

The block number is a sequential number of each block. The block number of each encoded block 132 is a value that is equal to or greater than 0 and less than or equal to $K_1-1$, and the block number of each redundant data block 133 is a value that is equal to or greater than $K_1$ and less than or equal to $K_1+M-1$, as a specific example.

(Step S304)

The additional transmission determination unit 112 obtains from the reception unit 122, the reception response addressed to the data transmission apparatus 100, which has been transmitted by the data reception apparatus 200.

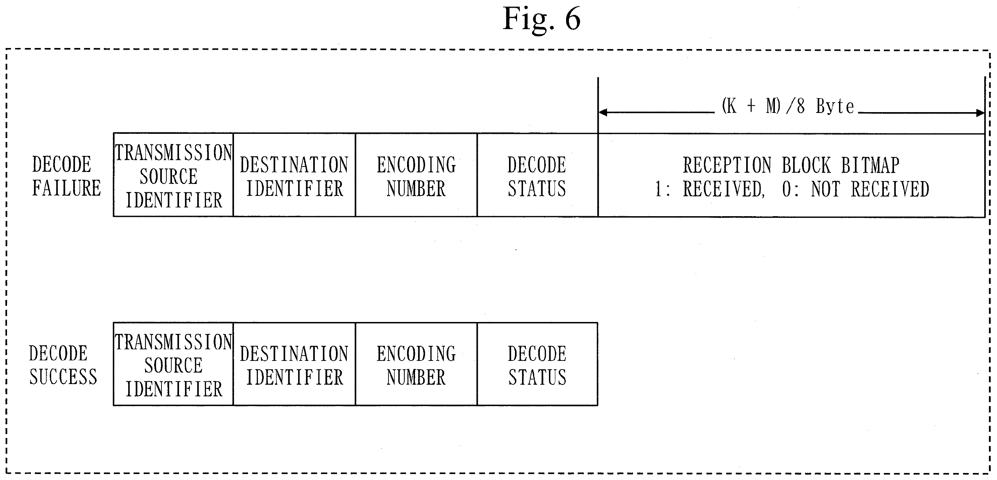

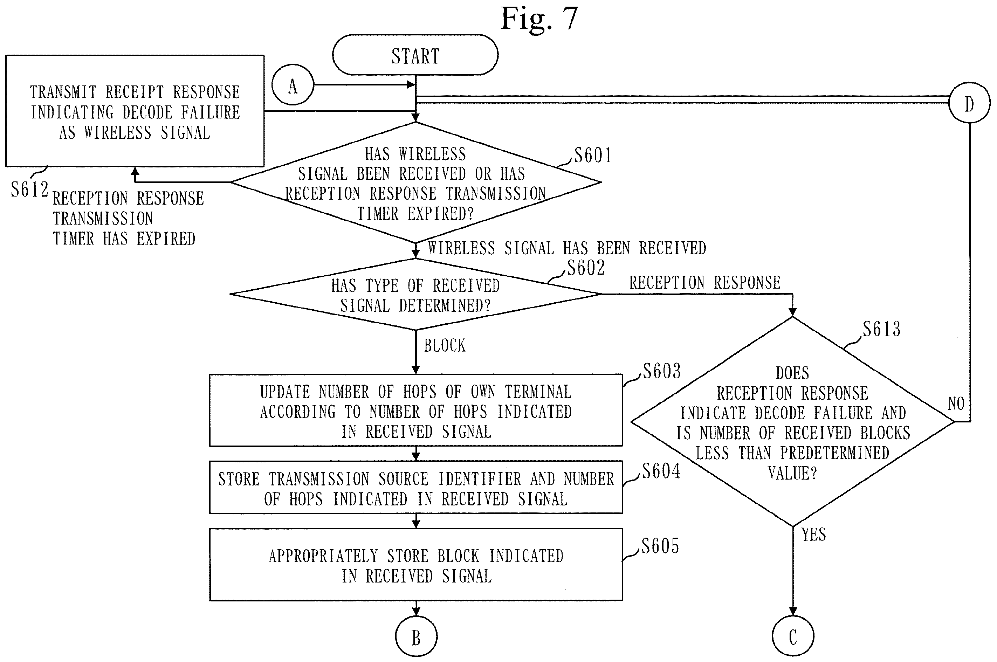

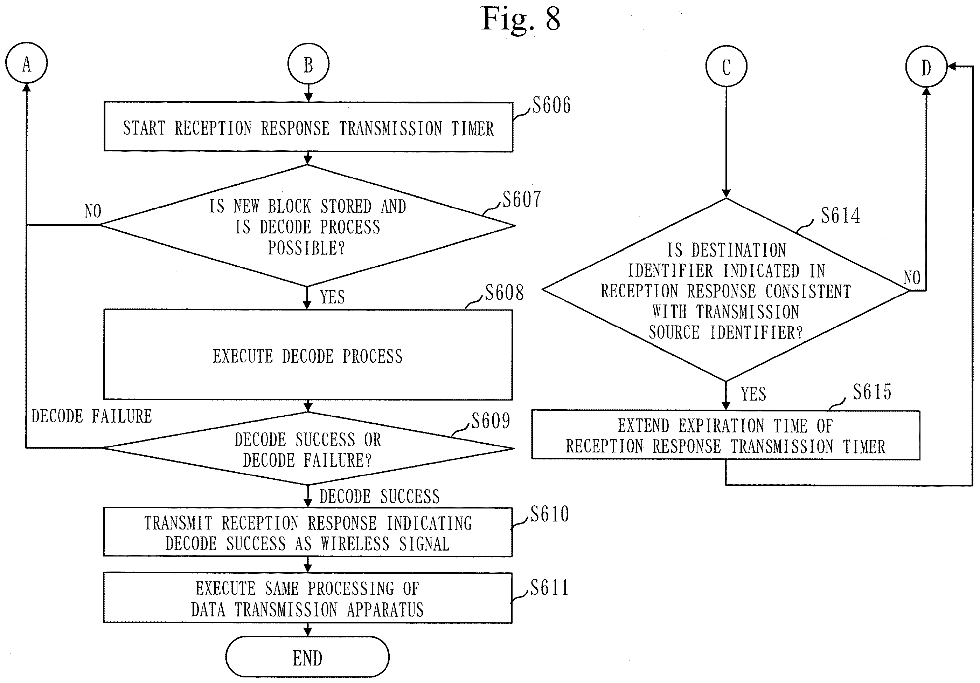

Fig. 6 illustrates an example of the format of the reception response. As illustrated in Fig. 6, the format of the reception response includes each of a transmission source identifier, a destination identifier, an encoding number, and a decode status. A reception response transmission process of the data reception apparatus 200 will be described below with reference to Figs. 7 and 8.

The destination identifier is information indicating the destination of the reception response.

The decode status is information indicating whether a decode process corresponding to the encoding number has succeeded or not. When the decode status indicates decode failure, the reception response includes a reception block bitmap.

The reception block bitmap is information indicating a bitmap in which each block has been received or not. The reception block bitmap is also information indicating the success or failure of reception for each block at the transmission source of the reception response including the corresponding reception block bitmap, and information indicating an identifier of each block received at the transmission source.

When there is distribution data 131 that has not been transmitted and remains in the memory unit 130, the data transmission apparatus 100 may execute the processing of the present flowchart in parallel to transmit the remaining distribution data 131 without waiting for the reception of the reception response from the data reception apparatus 200 in step S304. Further, the data transmission apparatus 100 may set a timeout period and wait for the reception response until the timeout period expires. When the apparatus identifiers of the data reception apparatuses 200 that are in the vicinity of the data transmission apparatus 100 are known in advance, the data transmission apparatus 100 may wait until the data transmission apparatus 100 has received reception responses from all the data reception apparatuses 200 that are in the vicinity.

(Step S305)

When all the reception responses received by the reception unit 122 from the data reception apparatus 200 indicate decode success, the data transmission apparatus 100 ends the transmission of the distribution data 131. When there is any remaining distribution data 131 that has not been distributed, the data transmission apparatus 100 repeats the processing of the present flowchart for the remaining distribution data 131.

When one or more reception responses among the reception responses received by the reception unit 122 from the data reception apparatus 200 indicate decode failure, the data transmission apparatus 100 proceeds to step S306. The processes from step S306 onwards are processes for the data reception apparatus 200 corresponding to the reception response indicating the decode failure.

(Step S306)

The additional transmission determination unit 112 calculates the minimum value $R_{min}$ of the number of received blocks from the reception block bitmap indicated in the reception response. Further, the additional transmission determination unit 112 obtains the number of each block that has not been received by the data reception apparatus 200 that has failed to decode.

(Step S307)

The additional transmission determination unit 112 checks whether or not the number of blocks that have not been notified to the transmission unit 121 in steps S303, S308 and S310 among the encoded block 132 and the redundant data block 133, that is, the number of blocks that are still associated with information indicating untransmitted in the memory unit 130, is equal to or greater than $K_2$-$R_{min}$.

When the number of blocks that have not been transmitted is equal to or greater than $K_2$-$R_{min}$, the data transmission apparatus 100 proceeds to step S308. Otherwise, the data transmission apparatus 100 proceeds to step S309.

(Step S308)

The additional transmission determination unit 112 selects the $K_2$-$R_{min}$ pieces of blocks from among the blocks that have not been transmitted, and notifies the transmission unit 121 of the selected $K_2$-$R_{min}$ pieces of blocks. The transmission unit 121 transmits the notified $K_2$-$R_{min}$ pieces of blocks as wireless signals.

Further, the additional transmission determination unit 112 associates each block with information indicating that the selected $K_2$-$R_{min}$ pieces of blocks have been transmitted, in the memory unit 130.

(Step S309)

First, the additional transmission determination unit 112 notifies the transmission unit 121 of all the blocks that have not been transmitted. The transmission unit 121 transmits the notified blocks as wireless signals.

Next, in the memory unit 130, the additional transmission determination unit 112 associates each block notified in the present step with information indicating that each block has been transmitted.

When there is no block that has not been transmitted, the additional transmission determination unit 112 does not notify the transmission unit 121 of any block.

(Step S310)

The additional transmission determination unit 112 refers to the reception block bitmap indicated in the reception response received from each of the data reception apparatuses 200, selects from among the blocks that have not been received at each of the data reception apparatuses 200, $K_2$-$R_n$-T pieces of blocks except for the blocks transmitted in step S309, where the $K_2\text{-}R_{n}\text{-}T$ pieces of blocks is the difference between $K_2\text{-}R_n$ pieces of blocks, which is the difference between $K_2$ and the number of received blocks $R_n$ of each of the data reception apparatuses 200, and the number of blocks T transmitted in step S309, and notifies the transmission unit 121 of the selected $K_2\text{-}R_{n}\text{-}T$ pieces of blocks. The transmission unit 121 transmits the notified $K_2\text{-}R_{n}\text{-}T$ pieces of blocks as wireless signals. A block to be transmitted in step S310 has already been associated with information indicating that the block has been transmitted in step S303 or S308, in the memory unit 130. Therefore, in step S310, it is not necessary to associate each block with information indicating that each block has been transmitted, in the memory unit 130. By the additional transmission determination unit 112 preferentially selecting blocks with a relatively large number of data reception apparatuses 200 that have not received the blocks, it is possible to reduce the number of blocks to be transmitted and improve efficiency. T is a positive integer.

After executing step S308 or step S310, the additional transmission determination unit 112 re-obtains the reception response transmitted by each of the data reception apparatuses 200 in step S304, and checks whether or not all the data reception apparatuses 200 have succeeded in decoding in step S305.

After that, when all the data reception apparatuses 200 have succeeded in the decode process, the data transmission apparatus 100 ends the processing of the present flowchart.

Figs. 7 and 8 is a flowchart illustrating an example of operation of the data reception apparatus 200. The operation of the data reception apparatus 200 will be described with reference to Figs. 7 and 8. The present flowchart will be described based on the assumption that a subject reception apparatus which is the data reception apparatus 200 executes the processing of the present flowchart. In the description of the present flowchart, each unit of the data reception apparatus 200 refers to each unit of the subject reception apparatus.

(Step S601)

The decode processing unit 213 waits until the reception unit 222 receives a wireless signal, or until the reception response transmission timer expires.

When the reception unit 222 has received the wireless signal, the subject reception apparatus proceeds to step S602. When the reception response transmission timer has expired, the subject reception apparatus proceeds to step S612. Hereafter, the wireless signal received in the present step is referred to as a received signal.

(Step S602)

The decode processing unit 213 determines the type of the received signal.

When the type of the received signal is the encoded block 132 or the redundant data block 133, the subject reception apparatus proceeds to step S603. Otherwise, the subject reception apparatus proceeds to step S613.

(Step S603)

When the value obtained by adding 1 to the number of hops indicated in the received signal is less than the value stored in the memory unit 230 as the number of hops of own terminal 134, or when no value has been stored as the number of hops of own terminal 134, the decode processing unit 213 updates the number of hops of own terminal 134 to the value obtained by adding 1 to the number of hops indicated in the received block.

(Step S604)

The decode processing unit 213 stores information indicating each of the transmission source identifier, the number of hops, and the block number indicated in the received signal, into the transmission source information 235 located in the memory unit 230.

(Step S605)

When the block indicated in the received signal is not stored in the memory unit 230, the decode processing unit 213 stores the block indicated in the received signal in the memory unit 230, and also notifies the reception response unit 214 that the block has been newly received.

(Step S606)

The reception response unit 214 starts the reception response transmission timer. At this time, the reception response unit 214 randomly selects the expiration time of the reception response transmission timer from the time between a time $T_1$ and a time $T_2$. When the reception response transmission timer has already started, the reception response unit 214 stops the already started reception response transmission timer and starts a new reception response transmission timer only if the selected expiration time is later than the expiration time of the already started reception response transmission timer. Here, as indicated in each of [Formula 1] and [Formula 2], by setting each of the times of $T_1$ and $T_2$ longer as the total number $R_n$ of received blocks increases, it is possible to delay the transmission of the reception response. In [Formula 1] and [Formula 2], each of $\alpha$ and $\beta$ is a coefficient, $T_{1b}$ indicates the reference time for $T_1$, and $T_{2b}$ indicates the reference time for $T_2$. Each of the values of $\alpha$, $\beta$, $T_{1b}$, and $T_{2b}$ is set as a parameter to the subject reception apparatus.

[Formula 1]

$$T_1 = (1 + \alpha R_n)T_{1b}$$

[Formula 2]

$$T_2 = (1 + \beta R_n)T_{2b}$$

(Step S607)

When a new block has been stored in step S605, and when the minimum number of blocks required for the decode process has been stored in the memory unit 230, the subject reception apparatus proceeds to step S608.

When a new block has not been stored in step S605, or when the minimum number of blocks required for the decode process has not been stored in the memory unit 230, the subject reception apparatus returns to step S601.

(Step S608)

The decode processing unit 213 executes the decode process using the blocks stored in the memory unit 230. When the decode process is successful, the decode processing unit 213 stores the decoded $K_1$ pieces of encoded blocks 132 in the memory unit 230, as the encoded blocks 132 and the distribution data 131.

(Step S609)

The decode processing unit 213 notifies the reception response unit 214 of a decode result in step S608.

When the notified decode result indicates decode failure, the subject reception apparatus returns to step S601. When the notified decode result indicates decode success, the subject reception apparatus proceeds to step S610.

(Step S610)

The reception response unit 214 creates a reception response indicating the decode success, and notifies the transmission unit 221 of the created reception response. At this time, the reception response unit 214 may set the apparatus identifiers indicating all other apparatuses as the destination identifiers of the reception response, for transmission using multicast. Further, the reception response unit 214 may set the transmission source identifier stored in the transmission source information 235, for transmission using unicast addressed to the apparatus set as the destination identifier.

In the present step, the transmission unit 221 does not need to immediately transmit the reception response. When the present embodiment is applied in a network that uses Routing Protocol for Low-Power and Lossy Networks (RPL Internet Protocol version 6 (IPv6 )), the transmission unit 221 may transmit the reception response by superimposing the reception response on an option area of DODAG Information Object (DIO) or Destination Advertisement Object (DAO).

(Step S611)

The subject reception apparatus can distribute the distribution data 131 to the data reception apparatus 200 at the next hop by executing the same operation as the operation of the data transmission apparatus 100, that is, the operation illustrated in Fig. 4, using the distribution data 131 stored in step S608. When the subject reception apparatus does not receive any reception response addressed to the subject reception apparatus in step S304, the subject reception apparatus may assume that there is no data reception apparatus 200 at the next hop, and stop the distribution to the data reception apparatus 200 at the next hop.

(Step S612)

When the reception response transmission timer has expired in step S601, the reception response unit 214 creates a reception response indicating the decode failure based on the reception status of the blocks stored in the memory unit 230, and notifies the transmission unit 221 of the created reception response. At this time, the reception response unit 214 selects from among the transmission source identifiers stored in the transmission source information 235 in the memory unit 230, one transmission source identifier corresponding to the number of hops that is less than the number of hops stored as the number of hops of own terminal 134, and sets the selected transmission source identifier as the destination identifier of the reception response. When there is no transmission source identifier corresponding to the number of hops that is less than the number of hops stored as the number of hops of own terminal 134 among the transmission source identifiers stored in the transmission source information 235, the reception response unit 214 may select the transmission source identifier corresponding to the number of hops that is greater than the number of hops stored as the number of hops of own terminal 134. The transmission unit 221 transmits the notified reception response as a wireless signal.

Here, by setting the transmission source identifier corresponding to the data reception apparatus 200 from which the subject reception apparatus has received the most blocks among the data reception apparatuses 200 which are the transmission sources of the blocks received by the subject reception apparatus, as the destination identifier of the reception response, the subject reception apparatus can receive a block that is additionally transmitted, in a more stable manner.

The reception response is transmitted using multicast, so that other data reception apparatuses 200 can also receive the reception response. However, when the data reception apparatus 200 other than the data reception apparatuses 200 corresponding to the destination identifiers can receive the reception response even when the reception response is transmitted using unicast, the transmission unit 221 may transmit the reception response using unicast to the data reception apparatus 200 that has been set as the destination identifier of the reception response.

After the transmission of the reception response, the subject reception apparatus returns to step S601.

(Step S613)

When the type of the received signal is a reception response and the reception response indicated in the received signal indicates reception failure, and when the number of received blocks is less than the total number of blocks stored in the memory unit 230, the subject reception apparatus proceeds to step S614.

When the reception response indicated in the received signal indicates reception success, or when the number of received blocks is equal to or greater than the total number of blocks stored in the memory unit 230, the subject reception apparatus returns to step S601.

(Step S614)

When the destination identifier indicated in the reception response is consistent with the transmission source identifier stored in the transmission source information 235, the subject reception apparatus proceeds to step S615. Otherwise, the subject reception apparatus returns to step S601.

(Step S615)

When there is the reception response transmission timer that has already started, the reception response unit 214 extends the expiration time of the reception response transmission timer. The extension time may be a longer time than a time taken for an additional block to be transmitted after the destination terminal has received the reception response indicated in the received signal. Here, the time taken for an additional block to be transmitted corresponds to a processing time.

*** Description of Effects of Embodiment 1 ***

According to the present embodiment, as described above, when content distribution is executed using the erasure correction coding in a multi hop network, each of the data reception apparatuses 200 transmits a reception response only when a certain condition is satisfied. Therefore, according to the present embodiment, as the number of transmissions of reception responses is reduced, it is possible to improve communication efficiency.

*** Other Configurations ***

<Modification 1>

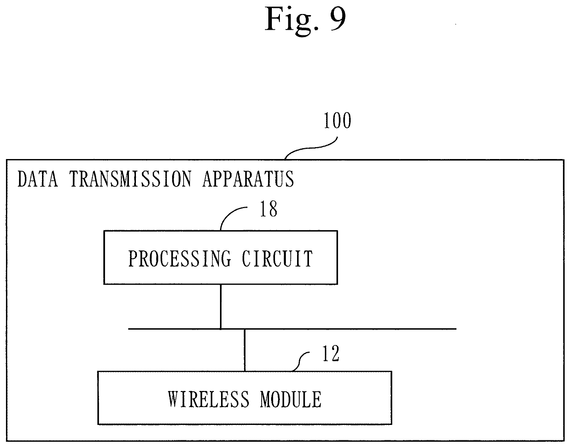

Fig. 9 illustrates an example of a hardware configuration of the data transmission apparatus 100 according to the present modification.

The data transmission apparatus 100 includes the processor 11, or a processing circuit 18 in place of the processor 11 and the storage device 13.

The processing circuit 18 is hardware that implements at least a part of the units included in the data transmission apparatus 100.

The processing circuit 18 may be dedicated hardware, or may be a processor that executes a program stored in the storage device 13.

When the processing circuit 18 is the dedicated hardware, a specific example of the processing circuit 18 is a single circuit, a composite circuit, a programmed processor, a parallel programmed processor, an Application Specific Integrated Circuit (ASIC), a Field Programmable Gate Array (FPGA), or a combination thereof.

The data transmission apparatus 100 may include a plurality of processing circuits as an alternative to the processing circuit 18. The plurality of processing circuits share the role of the processing circuit 18.

In the data transmission apparatus 100, some functions may be implemented by the dedicated hardware, and the remaining functions may be implemented by software or firmware.

The processing circuit 18 is implemented by, as a specific example, hardware, software, firmware, or a combination thereof.

The processor 11, the storage device 13, and the processing circuit 18 are collectively referred to as "processing circuitry". That is, the functions of the individual functional components of the data transmission apparatus 100 are implemented by the processing circuitry.

The data reception apparatus 200 may also have the same configuration as in the present modification. The data transmission apparatus 100 and the data reception apparatus 200 according to other embodiments may also have the same configurations as in the present modification.

Embodiment 2.

Hereinafter, differences from Embodiment 1 will be mainly described with reference to the drawings.

*** Description of Configuration ***

The content distribution system 90 according to the present embodiment includes a plurality of data reception apparatuses 200B in place of the plurality of data reception apparatuses 200.

The data transmission apparatus 100 according to the present embodiment is the same as the data transmission apparatus 100 according to Embodiment 1.

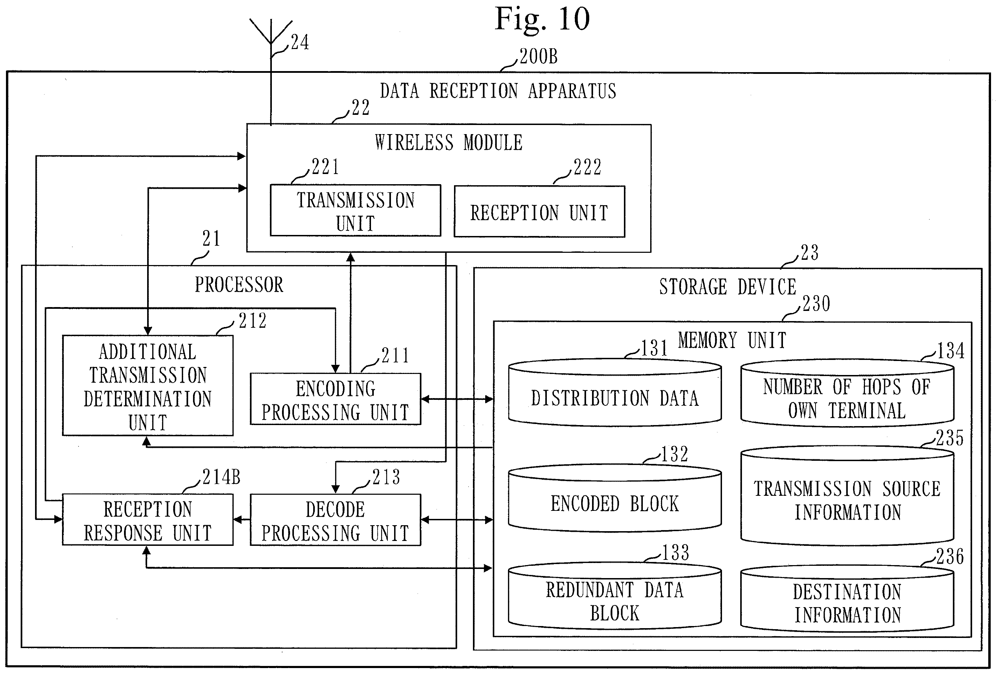

Fig. 10 is a diagram illustrating an example of a configuration of the data reception apparatus 200B according to the present embodiment.

The hardware configuration of the data reception apparatus 200B is the same as the hardware configuration of the data reception apparatus 200.

The data reception apparatus 200B includes a reception response unit 214B in place of the reception response unit 214, as a functional component.

The reception response unit 214B has a function to generate destination information 236 in addition to the function of the reception response unit 214.

The memory unit 230 according to the present embodiment further stores the destination information 236.

The destination information 236 is information indicating the destination identifier indicated in the reception response received by the data reception apparatus 200B, and information indicating the destination identifier indicated in each reception response received by the subject distribution apparatus for each content distribution apparatus that is the transmission source of the reception response received by the subject distribution apparatus.

In the present embodiment, the transmission unit 221 of the subject distribution apparatus transmits the reception response indicating a subject identifier as the destination identifier, after the reception response transmission timer has expired. The subject identifier is the apparatus identifier selected from among the transmission source identifiers corresponding to content distribution apparatuses whose number of receptions $R_n$ of blocks received from each content distribution apparatus by the subject distribution apparatus is greater than a threshold value $R_{th}$, among the transmission source identifiers included in the transmission source information 235. The subject identifier is also the apparatus identifier that is set as the destination identifier of each reception response received by the subject distribution apparatus from relatively large number of content distribution apparatuses, among the destination identifiers indicated in the destination information 236.

*** Description of Operation ***

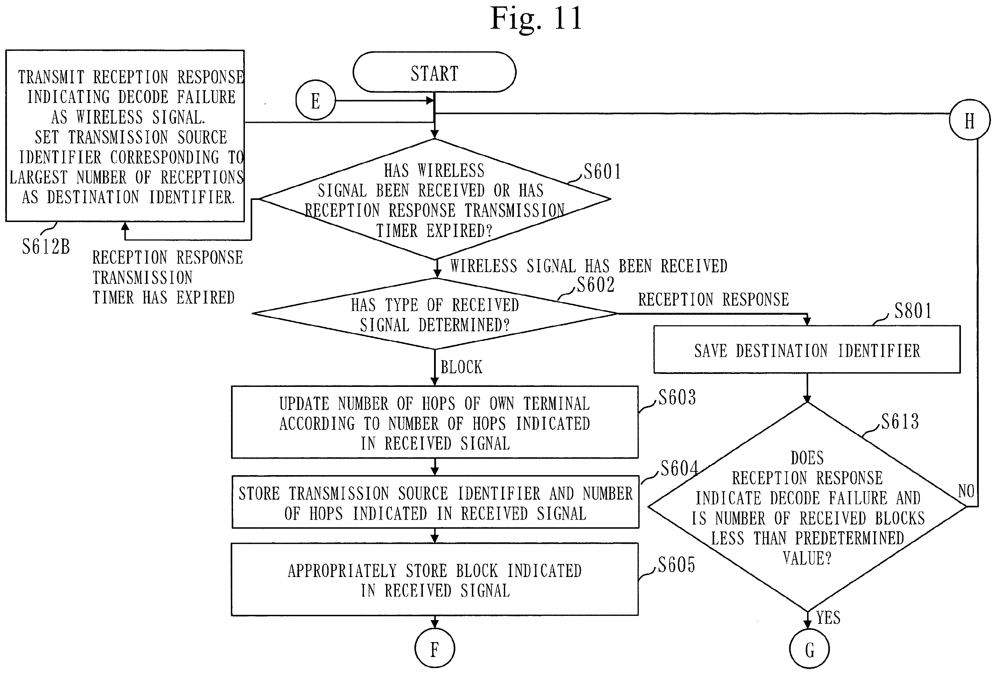

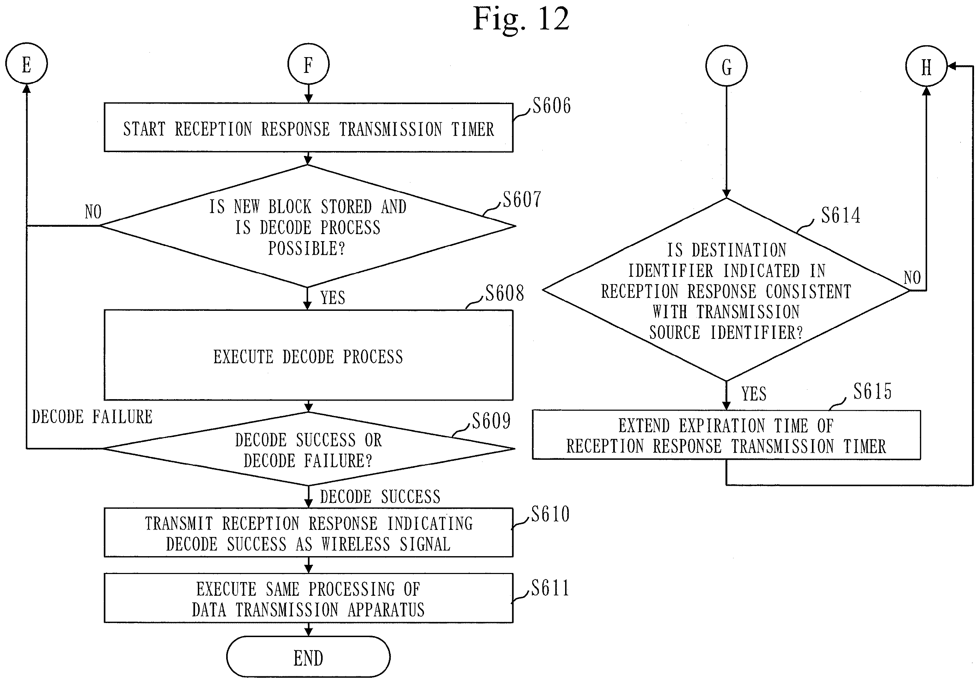

Figs. 11 and 12 is a flowchart illustrating an example of operation of the data reception apparatus 200B.

The differences between the operation of the data reception apparatus 200 and the operation of the data reception apparatus 200B are the addition of step S801 and the replacement of step S612 with step S612B.

Since the steps other than those related to the differences are as described above, the steps related to the differences will be described. The present flowchart will be described on the assumption that a subject reception apparatus which is the data reception apparatus 200B executes the processing of the present flowchart.

(Step S801)

When the type of the reception response is the received signal, the reception response unit 214B stores in the destination information 236 in the memory unit 230, the destination identifier indicated in the reception response indicated in the received signal, for each transmission source identifier indicated in the reception response.

After that, the subject reception apparatus proceeds to step S613.

(Step S612B)

The reception response unit 214B creates a reception response indicating the decode failure based on the reception status of the blocks stored in the memory unit 230. At this time, the reception response unit 214B selects from among the destination identifiers stored in the destination information 236, the apparatus identifier that is the same as each transmission source identifier corresponding to the number of hops that is less than the number of hops of own terminal 134, among the transmission source identifiers stored in the transmission source information 235, as an element of a selection identifier group. The reception response unit 214B refers to the destination information 236, selects from among the apparatus identifiers included in the selection identifier group, the apparatus identifier set as the destination identifier of the reception response by the largest number of data reception apparatuses 200B, as the subject identifier, and sets the selected subject identifier as the destination identifier of the reception response.

When there is no destination identifier corresponding to the number of hops that is less than the number of hops of own terminal 134 among the destination identifiers stored in the destination information 236, the reception response unit 214B executes the same process as step S612. Here, the number of hops corresponding to the destination identifiers is the number of hops stored in the transmission source information 235.

Here, the reception response unit 214B selects the subject identifier, taking into account the total number $R_n$ of blocks received by the subject reception apparatus from each of the data reception apparatuses 200B.

At this time, as a specific example, first, the reception response unit 214B refers to the transmission source information 235 and checks whether or not the total number $R_n$ of blocks received by the subject reception apparatus from the data reception apparatus 200B corresponding to the subject identifier is less than a

threshold value $R_{th1}$. The threshold value $R_{th1}$ may be set in any way.

Next, when the total number $R_n$ is less than the threshold value $R_{th1}$, the reception response unit 214B selects the apparatus identifier that has been set as the apparatus identifier of the reception response by the next largest number of data reception apparatuses 200B to the subject identifier among the apparatus identifiers included in the selection identifier group, as the second subject identifier. After that, the reception response unit 214B refers to the transmission source information 235 to check the total number $R_{n2}$ of blocks received by the subject reception apparatus from the data reception apparatus 200B corresponding to the second subject identifier. When the checked total number $R_{n2}$ is equal to or greater than the threshold value $R_{th1}$, the reception response unit 214B sets the second subject identifier as the destination identifier of the reception response.

When the total number $R_{n2}$ is less than the threshold value $R_{th1}$, the reception response unit 214B executes the above processing with the second subject identifier as the subject identifier. Further, when the total number of blocks received by the subject reception apparatus from the data reception apparatus 200B corresponding to each destination identifier stored in the destination information 236 is all less than the threshold value $R_{th1}$, the reception response unit 214B sets the apparatus identifier corresponding to the data reception apparatus 200B from which the subject reception apparatus has received the largest total number of blocks, as the destination identifier of the reception response.

After the transmission of the reception response, the subject reception apparatus returns to step S601.

*** Description of Effects of Embodiment 2 ***

In the present embodiment, as described above, in the plurality of data reception apparatuses 200B, by setting the apparatus identifier of the data reception apparatus 200B corresponding to the apparatus identifier set as the destination identifier of the reception response by the larger number of data reception apparatuses 200B, as the destination identifier of the reception response, the data reception apparatuses 200 that transmit blocks are narrowed down. Therefore, according to the present embodiment, it is possible to improve distribution efficiency further.

Embodiment 3.

Hereinafter, differences from Embodiment 2 will be mainly described with reference to the drawings.

*** Description of Configuration ***

The content distribution system 90 according to the present embodiment includes a plurality of data reception apparatuses 200C in place of the plurality of data reception apparatuses 200B.

The data transmission apparatus 100 according to the present embodiment is the same as the data transmission apparatus 100 according to Embodiment 1.

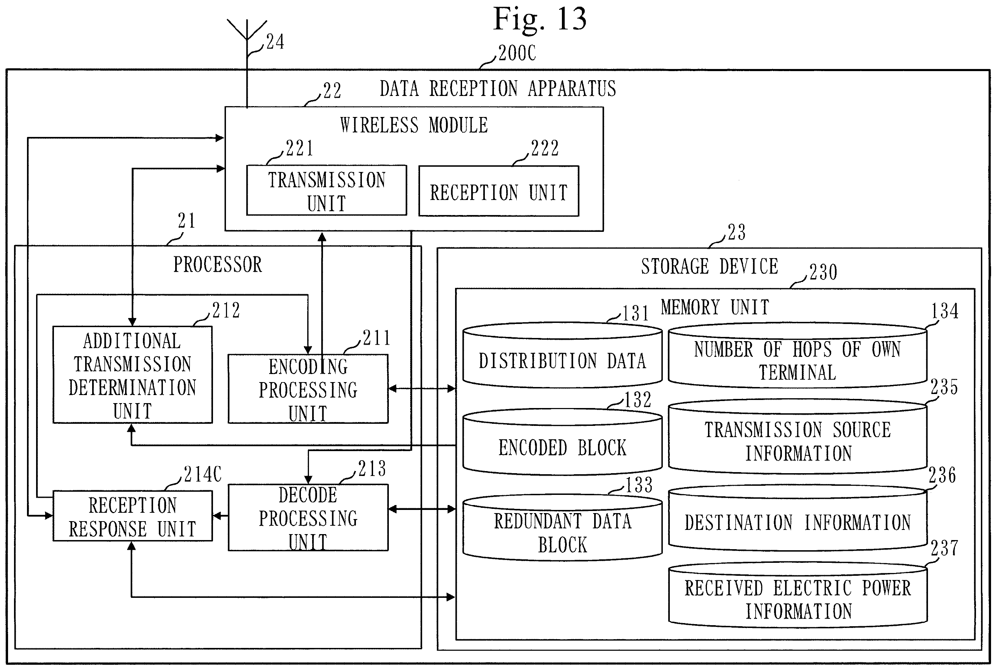

Fig. 13 is a diagram illustrating an example of a configuration of the data reception apparatus 200C according to the present embodiment.

The hardware configuration of the data reception apparatus 200C is the same as the hardware configuration of the data reception apparatus 200B.

The data reception apparatus 200C includes a reception response unit 214C in place of the reception response unit 214B, as a functional component.

The reception response unit 214C has a function to generate received electric power information 237 in addition to the function of the reception response unit 214B.

The memory unit 230 according to the present embodiment further stores the received electric power information 237.

The received electric power information 237 is information indicating received electric power corresponding to the blocks received by the data reception apparatus 200C for each transmission source of the blocks, and is information indicating the received electric power corresponding to each block received by the subject distribution apparatus.

*** Description of Operation ***

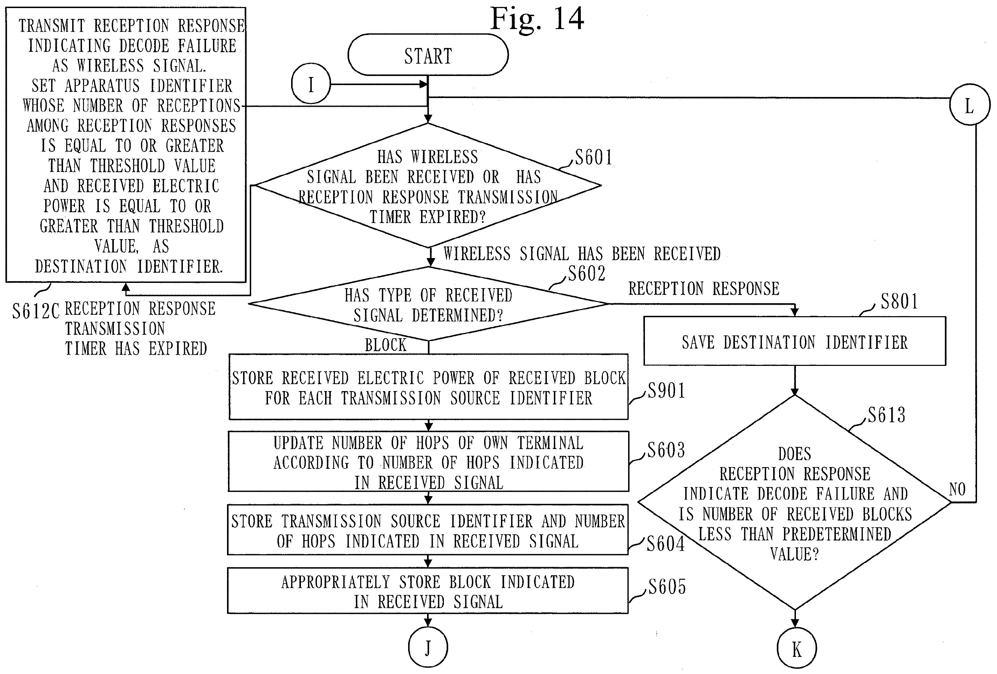

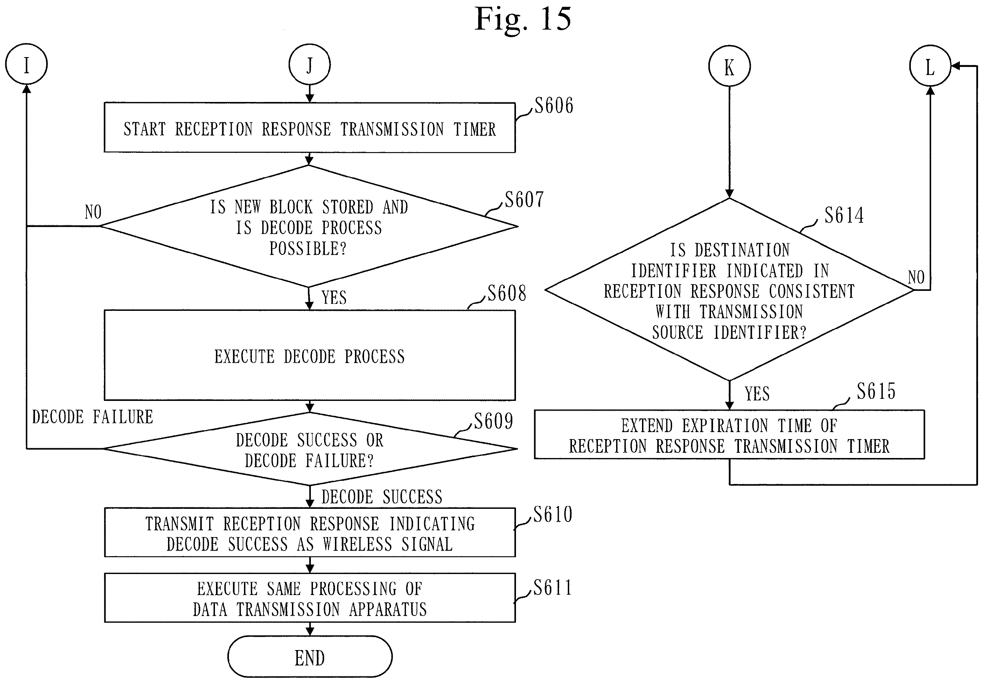

Figs. 14 and 15 is a flowchart illustrating an example of operation of the data reception apparatus 200C.

The difference between the operation of the data reception apparatus 200B and the operation of the data reception apparatus 200C are the addition of step S901 and the replacement of step S612B with step S612C. Since the steps other than those related to the differences are as described above, the steps related to the differences will be described. The present flowchart will be described on the assumption that a subject reception apparatus which is the data reception apparatus 200C executes the processing of the present flowchart.

(Step S901)

When the type of the received signal is the encoded block 132 or the redundant data block 133, the reception response unit 214C stores the received electric power of the received signal in the received electric power information 237 in the memory unit 230, for each transmission source identifier corresponding to the block indicated in the received signal. At this time, the reception response unit 214C stores each of the average value, the median value , and the minimum value of the received electric power, for each transmission source identifier in the received electric power information 237.

After that, the subject reception apparatus proceeds to step S603.

(Step S612C)

The reception response unit 214C sets the subject identifier as the destination identifier of the reception response, as in step S612B.

When there is no destination identifier corresponding to the number of hops that is less than the number of hops of own terminal 134 among the destination identifiers stored in the destination information 236, the reception response unit 214C executes the same process as step S612.

Here, the reception response unit 214C selects the subject identifier, taking into account the total number $R_n$ of blocks received from each of the data reception apparatuses 200C and the received electric power corresponding to the received blocks.

At this time, as a specific example, first, the reception response unit 214C refers to the transmission source information 235 and checks whether or not the total number $R_n$ of blocks received by the subject reception apparatus from the data reception apparatus 200C corresponding to the subject identifier is less than a threshold value $R_{th2}$. Further, the reception response unit 214C refers to the received electric power information 237 and checks whether the average value, the median value, or the minimum value of the received electric power corresponding to the data reception apparatus 200C corresponding to the subject identifier is less than the threshold value $P_{th}$. Each of the threshold value $P_{th}$ and the threshold value $R_{th2}$ may be set in any way. The threshold value $R_{th2}$ may be the same as the threshold value $R_{th1}$.

Next, when the total number $R_n$ is less than the threshold value $R_{th2}$, or the average value, the median value, or the minimum value of the received electric power is less than the threshold value $P_{th}$, the reception response unit 214C selects the apparatus identifier that has been set as the apparatus identifier of the reception response by the next largest number of data reception apparatuses 200B to the subject identifier among the apparatus identifiers included in the selection identifier group, as the second subject identifier. After that, the reception response unit 214C similarly checks the total number $R_n$ of blocks corresponding to the second subject identifier and the received electric power corresponding to the second subject identifier. When the checked total number $R_n$ is less than the threshold value $R_{th2}$ or when the checked average value, median value, or minimum value of the received electric power is less than the threshold value $P_{th}$, the reception response unit 214C executes the processing described above with the second subject identifier as the subject identifier.

When the total number and the received electric power of blocks corresponding to the data reception apparatus 200C corresponding to each destination identifier stored in the destination information 236 are all less than the predetermined threshold values, the reception response unit 214C sets the apparatus identifier corresponding to the data reception apparatus 200C from which the subject reception apparatus has received the largest total number of blocks, as the destination identifier of the reception response.

After the transmission of the reception response, the data reception apparatus 200C returns to step S601. In the present embodiment, the subject identifier is the apparatus identifier selected from among the transmission source identifiers whose received electric power corresponding to the corresponding block is equal to or greater than the threshold value $P_{th}$.

*** Description of Effects of Embodiment 3 ***

In the present embodiment, as described above, in the plurality of data reception apparatuses 200C, the apparatus identifier of the data reception apparatus 200C corresponding to the apparatus identifier set as the destination identifier of the reception response by the larger number of data reception apparatuses 200C, which corresponds to the apparatus identifier selected taking into account the relative strength of the received electric power of the block in each data reception apparatus 200C, is set as the destination identifier of the reception response. Therefore, according to the present embodiment, while narrowing down the data reception apparatuses 200C that transmit blocks, it is possible to improve the distribution efficiency through stable communication.

Embodiment 4.

Hereinafter, differences from the embodiments described above will be mainly described with reference to the drawings.

*** Description of Configuration ***

The configuration of the content distribution system 90 according to the present embodiment is the same as the configuration described in any of Embodiments 1 to 3.

In the present embodiment, the format of the reception response in the event of decode failure differs from that of Embodiments 1 to 3.

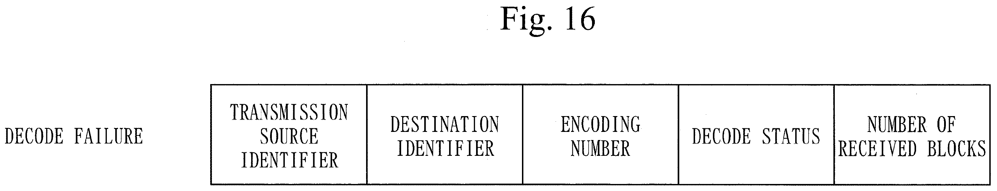

Fig. 16 is the format of the reception response that is transmitted by the data reception apparatus 200 according to the present embodiment, in the event of decode failure. In the present embodiment, in the event of decode failure, in addition to the format of the reception response in Embodiments 1 to 3, the format is used in which the reception block bitmap part of the reception response is replaced with the number of received blocks.

The format of the reception response in the event of decode success is the same as the format of the reception response in Embodiments 1 to 3.

In the present embodiment, when the data reception apparatus 200 receives a block corresponding to a new encoding number, and fails the decode process corresponding to the received block, the format of the reception response in the event of decode failure illustrated in Fig. 16 is used for the encoding number corresponding to the received block.

In the present embodiment, during the time until the subject distribution apparatus receives the block that is transmitted at the last among the blocks . corresponding to the second subject content data which is content data, or during the time until the subject distribution apparatus receives a new block, the transmission unit 221 of the subject distribution apparatus transmits the reception response indicating the total number of blocks received by the subject distribution apparatus in place of the success or failure of reception for each block at the transmission source and the identifier of each block received at the transmission source, as the reception response corresponding to the second subject content data. The new block is a block generated at a time point that differs from a time point at which the received block has been generated, and is a block generated by executing the erasure correction coding on the second subject content data. The received block is a block corresponding to the second subject content data and is a block that has already been received by the subject distribution apparatus. A specific example of the new block is a block indicating the encoding number that differs from the encoding number indicated in the received block.

*** Description of Operation ***

In the present embodiment, in step S605, when the block number of the received block is checked, and the checked block number is the block number to be transmitted from the data transmission apparatus 100 at the last, the encoding number corresponding to the received block uses the format of the reception response in Embodiments 1 to 3.

Further, when the decode process for the distribution data 131 corresponding to the number before the encoding number of the received block has not succeeded, the format of the reception response in Embodiments 1 to 3 is used for each block corresponding to the number before the received encoding number.

In any case other than the case described above, the format of the reception response illustrated in Fig. 16 is used in the event of decode failure.

*** Description of Effect of Embodiment 4 ***

In the present embodiment, as described above, until the data transmission apparatus 100 have transmitted all blocks corresponding to the distribution data 131 corresponding to a certain encoding number, the format of the reception response in the event of decode failure is modified. Therefore, according to the present embodiment, it is possible to reduce the amount of communication of reception responses and improve the distribution efficiency.

Embodiment 5.

Hereinafter, differences from the embodiments described above will be mainly described with reference to the drawings.

*** Description of Configuration ***

The configuration of the content distribution system 90 according to the present embodiment is the same as the configuration of the content distribution system 90 described in any of Embodiments 1 to 4.

In the present embodiment, the selection method for the encoded block 132 and the redundant data block 133 to be transmitted by the additional transmission determination unit differs from that used in Embodiments 1 to 4. Specifically, the additional transmission determination unit randomly selects the $K_2$-$R_{min}$ pieces of blocks from among blocks that have not been transmitted among the $K_1$ pieces of encoded blocks 132 and the M pieces of redundant data blocks 133.

The format of each of the encoded block 132, the redundant data block 133, the reception response in the event of decode success, and the reception response in the event of decode failure is the same as each format indicated in Embodiments 1 to 4.

*** Description of Operation ***

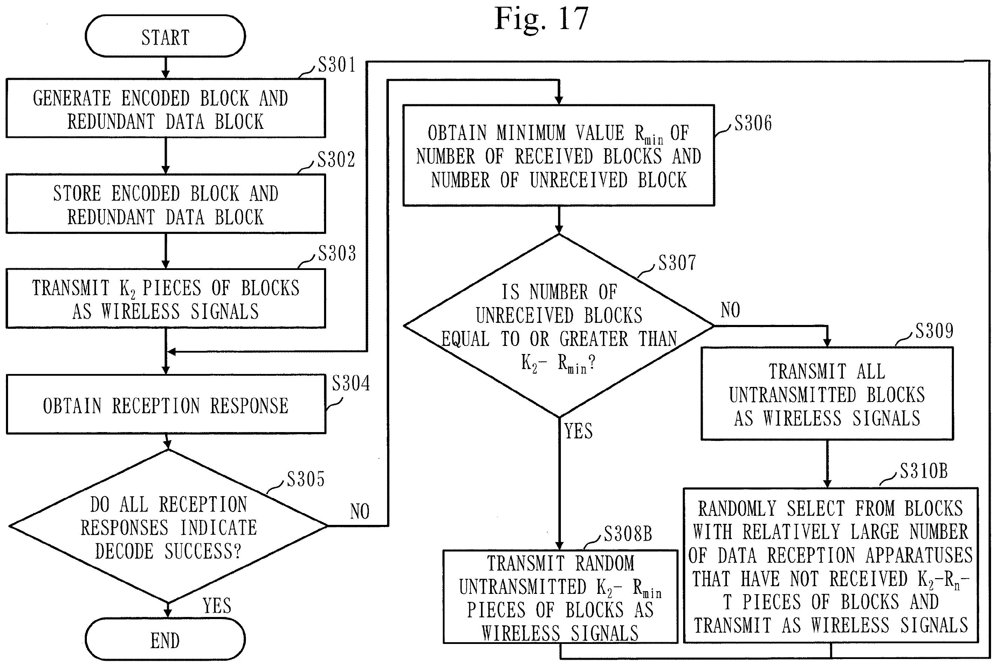

Fig. 17 is a flowchart illustrating an example of a distribution data process by the data transmission apparatus 100. A distribution data transmission process to the data reception apparatus 200 at the next hop by the data reception apparatus 200 is the same as the distribution data process. That is, operation of the additional transmission determination unit 212 is the same as operation of the additional transmission determination unit 112.

The differences in Fig. 17 with regard to Fig. 4 are steps S308B and S310B.

(Step S308B)

Step S308B is the same as step S308. However, when selecting the $K_2$-$R_{min}$ pieces of blocks, the additional transmission determination unit 112 randomly selects the $K_2$-$R_{min}$ pieces of blocks.

(Step S310B)

Step S310B is the same as step S310. However, when selecting the $K_2$-$R_n$-T pieces of blocks, the additional transmission determination unit 112 randomly selects the $K_2$-$R_n$-T pieces of blocks.

In the selection of random blocks in steps S308B and S310B, a different random number may be used for each of the data transmission apparatus 100 and the data reception apparatuses 200 using a hardware random number generator, and random numbers generated using the apparatus identifiers of the data transmission apparatus 100 and each data reception apparatus 200 may be used as seeds.

*** Description of Effects of Embodiment 5 ***

In the present embodiment, as described above, each of the data transmission apparatus 100 and the plurality of data reception apparatuses 200 randomly selects a block to be additionally transmitted after receiving the reception response of decode failure. Therefore, the probability of the data reception apparatus 200, to receive the same block, that receives the block additionally transmitted from the data transmission apparatus 100 or the plurality of data reception apparatuses 200 decreases. Thus, according to the present embodiment, it is possible to improve the probability of successful decode.

Embodiment 6.

Hereinafter, differences from the embodiments described above will be mainly described with reference to the drawings.

*** Description of Configuration ***

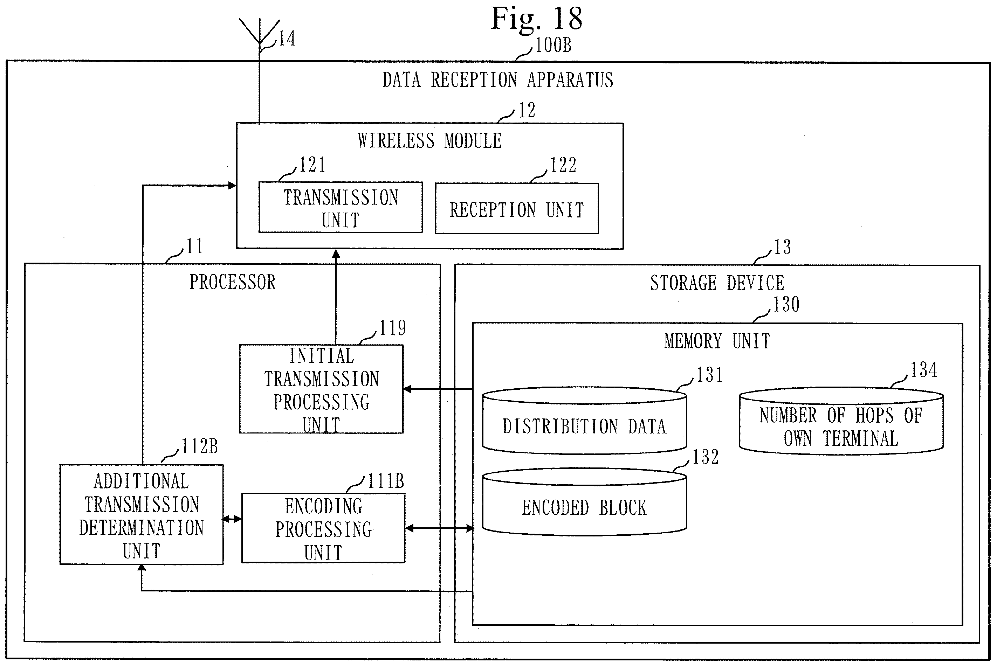

Fig. 18 illustrates an example of a configuration of a data transmission apparatus 100B according to the present embodiment. Compared to the configuration of the data transmission apparatus 100 indicated in any of Embodiments 1 to 3, the redundant data block 133 is removed from the memory unit 130 and an initial transmission processing unit 119 is added to the processor 11, in the data transmission apparatus 100B. Further, the data transmission apparatus 100B includes an encoding processing unit 111B in place of the encoding processing unit 111, and an additional transmission determination unit 112B in place of the additional transmission determination unit 112.

The encoding processing unit 111B divides the subject content data into the $K_1$ pieces of encoded blocks 132. Further, the encoding processing unit 111B encodes additional transmission data by encoding a plurality of encoded blocks 132 using a Fountain Code, specifically, a Luby Transform (LT) Code.

When the destination identifier indicated in each reception response received by the subject distribution apparatus is consistent with the apparatus identifier of the subject distribution apparatus, the encoding processing unit 111B of the subject distribution apparatus encodes a plurality of blocks selected from among blocks that have failed to be received as indicated in each reception response received by the subject distribution apparatus by the Fountain Code, and creates the additional transmission-data indicating the encoded plurality of blocks.

The additional transmission determination unit 112B transmits the additional transmission data generated by the encoding processing unit 111B, as the additional transmission data.

When the destination identifier indicated in each reception response received by the subject distribution apparatus is consistent with the apparatus identifier of the subject distribution apparatus, the additional transmission determination unit 112B selects a plurality of blocks from among blocks that have failed to be received as indicated in each reception response received by the subject distribution apparatus, as the plurality of blocks to be encoded by the encoding processing unit 111B, so that the created additional transmission data can be decoded in any of content distribution apparatuses that have failed to receive one or more blocks among content distribution apparatuses corresponding to each reception response received by the subject distribution apparatus, based on the success or failure of reception for each block indicated in each reception response received by the subject distribution apparatus.

The initial transmission processing unit 119 executes the initial transmission of the encoded block 132.

The transmission unit 121 according to the present embodiment transmits the $K_1$ pieces of encoded blocks 132, together with a transmission source identifier, as wireless signals. The transmission unit 121 of the subject distribution apparatus transmits the created additional transmission data as a wireless signal.

The reception unit 122 of the subject distribution apparatus receives the additional transmission data from another content distribution apparatus, as a wireless signal.

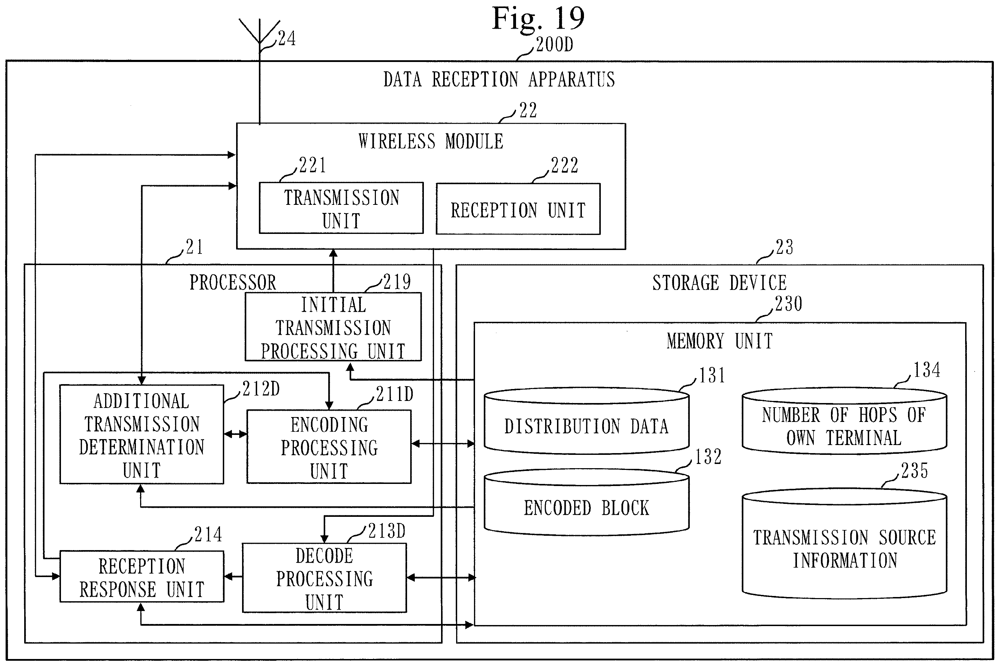

Fig. 19 illustrates an example of a configuration of a data reception apparatus 200D according to the present embodiment. Compared to the configuration of the data reception apparatus indicated in any of Embodiments 1 to 3, the redundant data block 133 is removed from the memory unit 230 and an initial transmission processing unit 219 is added to the processor 21, in the data reception apparatus 200D. Further, the data reception apparatus 200D includes an encoding processing unit 211D as the encoding processing unit, an additional transmission determination unit 212D as the additional transmission determination unit, and a decode processing unit 213D as the decode processing unit.

Although Fig. 19 is a diagram illustrating modifications from Embodiment 1, the same modifications may also be applied to Embodiments 2 and 3.

The encoding processing unit 211D is the same as the encoding processing unit 111B.

The additional transmission determination unit 212D is the same as the additional transmission determination unit 112B.

The initial transmission processing unit 219 is the same as the initial transmission processing unit 119.

The decode processing unit 213D decodes the additional transmission data received from the surrounding data reception apparatus 200D using the Fountain Code. That is, the decode processing unit 213D restores a plurality of blocks corresponding to the received additional transmission data by decoding the encoded plurality of blocks indicated in the additional transmission data received from the other content distribution apparatus, using the Fountain Code.

*** Description of Operation ***

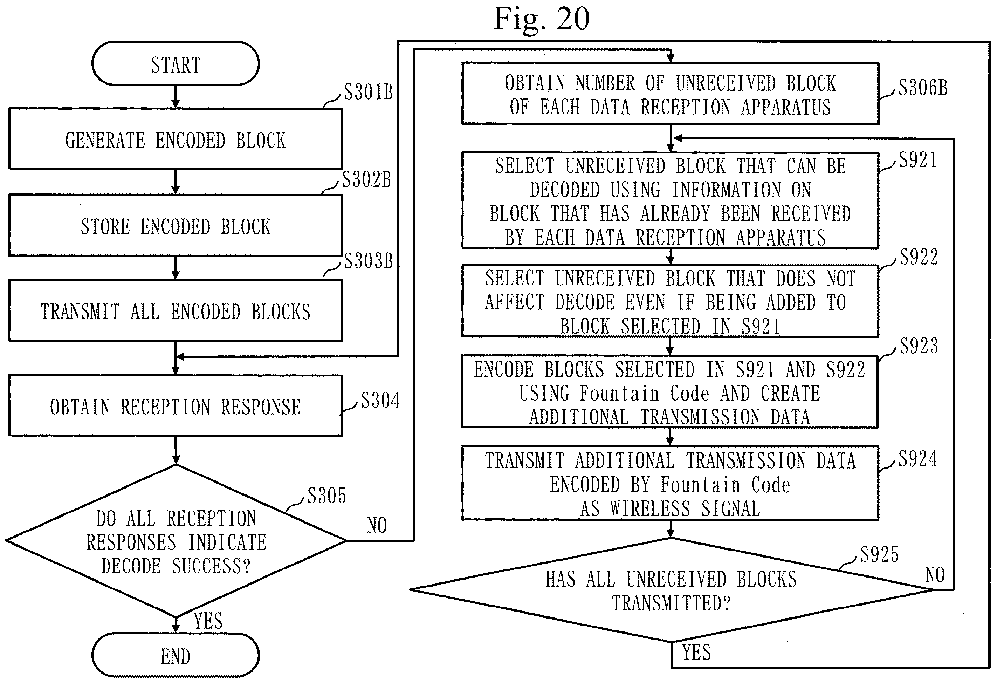

Fig. 20 is a flowchart illustrating an example of a distribution data process by the data transmission apparatus 100B according to the present embodiment. A distribution data transmission process to the data reception apparatus 200D at the next hop by the data reception apparatus 200D is the same as the distribution data process.

In the present embodiment, the Fountain Code, specifically the LT Code, is used as the erasure correction code, unlike in Embodiments 1 to 3. Although the processing of the data transmission apparatus 100B will be described below, the data reception apparatus 200D executes the same processing. In the present embodiment, compared to Embodiments 1 to 3, the distribution data transmission process and the additional transmission data transmission process differ, but the other processes remain the same.

(Step S301B)

The encoding processing unit 111B divides the distribution data 131 into the $K_1$ pieces of encoded blocks 132. Each of the encoded blocks 132 is merely a block generated by dividing the distribution data 131 and is a block that has not been encoded by the Fountain Code.

(Step S302B)

The encoding processing unit 111B stores into the memory unit 130, the $K_1$ pieces of encoded blocks 132 generated in step S301B.

(Step S303B)

The initial transmission processing unit 119 transmits all of the encoded blocks 132, as wireless signals. The format of the data being transmitted is the same as the transmission format of the encoded block 132 as illustrated in Fig. 5.

(Step S304)

The present step is the same as step S304 according to Embodiments 1 to 3. However, the additional transmission determination unit 112B obtains from the reception unit 122, the reception response, which has been transmitted by the data reception apparatus 200D, addressed to the data transmission apparatus 100B. The format of the reception response is the same as the format indicated in Embodiments 1 to 3.

(Step S305)

The present step is the same as step S305 according to Embodiments 1 to 3. However, when all the reception responses received by the reception unit 122 from the data reception apparatus 200D indicate decode success, the data transmission apparatus 100B ends the transmission of the distribution data 131. When there is any remaining distribution data 131 that has not been distributed, the data transmission apparatus 100B repeats the processing of the present flowchart for the remaining distribution data 131.

When one or more reception responses among the reception responses received by the reception unit 122 from the data reception apparatus 200D indicate decode failure, the data transmission apparatus 100B proceeds to step S306B. The processes from step S306B onwards are processes for the data reception apparatus 200D corresponding to the reception response indicating the decode failure.

(Step S306B)

The additional transmission determination unit 112B obtains the number of the encoded block 132 that has not been received by each data reception apparatus 200D corresponding to the reception response indicating the decode failure.

(Step S921)

First, the additional transmission determination unit 112B selects one of the encoded blocks 132 that has not been received by any of the data reception apparatuses 200D corresponding to the reception response indicating the decode failure, for use in the additional transmission data. After that, the additional transmission determination unit 112B includes all of one or more data reception apparatuses 200D that have not received the selected encoded block 132 in the selected apparatus list. At the start point of the present step, the selected apparatus list is an empty list.

Next, the additional transmission determination unit 112B executes an additional selection process. In the additional selection process, first, when there are encoded blocks 132 that have not been received by a certain data reception apparatus 200D other than the data reception apparatuses 200D included in the selected apparatus list, and that have been received by all of the data reception apparatuses 200D included in the selected apparatus list, the additional transmission determination unit 112B selects one of the encoded blocks 132 for use in the additional transmission data. In the additional selection process, next, all of one or more data reception apparatuses 200D that have not received the selected encoded block 132 are included in the selected apparatus list. The encoded block 132 selected in the additional selection process is equivalent to the encoded block to be used in the encoding by the Fountain Code in step S923.

Here, in step S923, the encoding processing unit 111B encodes the selected plurality of encoded blocks 132 using the Fountain Code, especially the LT Code, for the data series of the first selected encoded block 132. The encoding process by the Fountain Code, especially the LT Code, is an XOR operation of a plurality of data series. Therefore, the length of the data series remains the same before and after the encoding process.

After that, the additional transmission determination unit 112B repeatedly executes the additional selection process until there is no encoded block 132 that can be selected in the additional selection process.

In step S921, the encoded block 132 that has already been selected for use in the additional transmission data in the past in at least one of steps S921 and S922 is eliminated from the selection candidates. In the present step, one or more pieces and less than or equal to the $K_1$ pieces of encoded blocks 132 are selected.

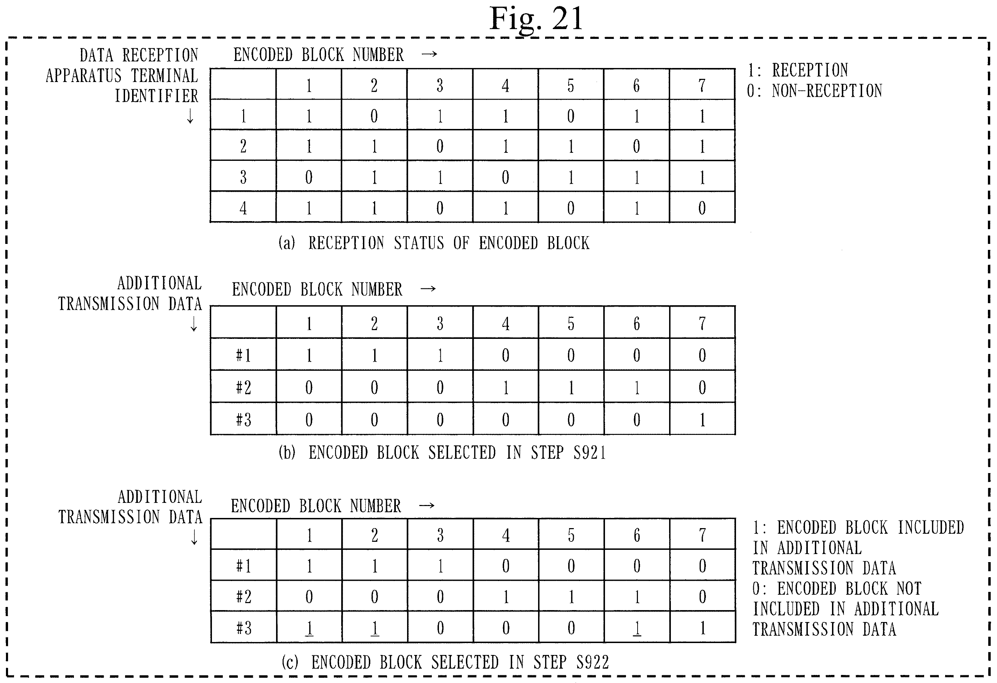

Fig. 21 illustrates an example of the reception status of the encoded block 132 in each data reception apparatus 200D, the number of each encoded block 132 selected for use in the additional transmission data in step S921, and the number of each encoded block 132 selected for use in the additional transmission data in step S922. In (a) of Fig. 21, "1" indicates reception, and "0" indicates non-reception. In (b) and (c) of Fig. 21, "1" indicates the encoded block 132 that is included in the additional transmission data, and "0" indicates the encoded block 132 that is not included in the additional transmission data. In the present example, the number of encoded blocks 132 is 7, and the number of data reception apparatuses 200D is 4. Further, due to the processes from steps S921 to S923 being repeated three times, three pieces of additional transmission data have been created.

In the example illustrated in (b) of Fig. 21, with regard to additional transmission data #1 created first in step S921, the additional transmission determination unit 112B first selects an encoded block 132 whose encoded block number is 1 for use in the additional transmission data, as the encoded block 132 that has not been received by any of data reception apparatuses 200D corresponding to the reception response indicating the decode failure. After that, since only the data reception apparatus 200D whose terminal identifier is 3 has not received the encoded block 132, the additional transmission determination unit 112B includes only this data reception apparatus 200D in the selected apparatus list.

Next, the additional transmission determination unit 112B executes the additional selection process. Specifically, the additional transmission determination. unit 112B selects an encoded block 132 whose encoded block number is 2 for use in the additional transmission data, as the encoded block 132 that has not been received by a certain data reception apparatus 200D other than the data reception apparatuses 200D included in the selected apparatus list, and that has been received by all of the data reception apparatuses 200D included in the selected apparatus list. After that, since only the data reception apparatus 200D whose terminal identifier is 1 has not received the encoded block 132, the additional transmission determination unit 112B includes only this data reception apparatus 200D in the selected apparatus list.

Next, the additional transmission determination unit 112B executes the additional selection process. Specifically, the additional transmission determination unit 112B selects an encoded block 132 whose encoded block number is 3 for use in the additional transmission data, as the encoded block 132 that has not been received by a certain data reception apparatus 200D other than the data reception apparatuses 200D included in the selected apparatus list, and that has been received by all of the data reception apparatuses 200D included in the selected apparatus list. After that, since the data reception apparatuses 200D whose terminal identifiers are 2 and 3 have not received the encoded block 132, these two data reception apparatuses 200D are included in the selected apparatus list.

Next, since there is no encoded block 132 that can be selected in the additional selection process, the additional transmission determination unit 112B ends the additional selection process.

As a result, the encoded block 132 corresponding to each of the encoded block numbers 1, 2, and 3 has been selected as the encoded block 132 for use in the additional transmission data with regard to the additional transmission data #1.

Similarly, the additional transmission determination unit 112B selects each of the encoded blocks 132 indicated in additional transmission data #2 and additional transmission data #3. Here, in the case of the additional transmission data #2 in (b) of Fig. 21, since the encoded blocks 132 corresponding to each of the encoded block numbers 1, 2, and 3 has been selected in the past in step S921, these three pieces of encoded blocks 132 are not selected.

In the present example, the additional transmission determination unit 112B determines whether or not there is the data reception apparatus 200D that has not received the encoded block 132 in ascending order from 1 with regard to the encoded block number, and selects the encoded block 132 to be included in the additional transmission data. However, the starting position of the determination may be a random position, and the order of the determination may be a random order.

(Step S922)

By executing a block addition process, the additional transmission determination unit 112B appropriately selects a decodable block related to the additional transmission data corresponding to the encoded block 132 selected in step S921, as the encoded block 132 to be used for encoding by the Fountain Code in step S923. When it is possible to decode the additional transmission data additionally encoded in all of the data reception apparatuses 200D even if a certain encoded block 132 is additionally encoded for the encoded block 132 selected for use in certain additional transmission data, the certain encoded block 132 is a decodable block related to the certain additional transmission data. Each data reception apparatus 200D corresponding to the reception response indicating the decode failure has not received one encoded block 132 at most, among the encoded blocks 132 indicated in each additional transmission data (including the additional transmission data additionally encoded). Further, even if, for certain additional transmission data, a data reception apparatus 200D that has not received the encoded block 132 indicated in the certain additional transmission data additionally encodes the encoded block 132 that has been received by the data reception apparatus 200D, the certain additional transmission data can be decoded with regard to the data reception apparatus 200D.

In the block addition process, first, when all data reception apparatuses 200D (the encoded block 132 that has not been received by each data reception apparatus 200D does not have to be identical) that have not received any one of encoded blocks 132 included in a selection block group have received a certain encoded block 132, at least one data reception apparatus 200D other than all of the data reception apparatuses 200D has not received the certain encoded block 132, and it is possible to decode the additional transmission data additionally encoded in all of the data reception apparatuses 200D even if the certain encoded block 132 is additionally encoded with regard to the additional transmission data corresponding to the selection block group, the additional transmission determination unit 112B selects the certain encoded block 132 for use in the additional transmission data related to the additional transmission data corresponding to the selection block group. In this case, the certain encoded block 132 is a decodable block related to the additional transmission data corresponding to the selection block group. The selection block group, at the start point of the present step, consists of one or more encoded blocks 132 selected in step S921. Further, the additional transmission determination unit 112B adds the selected encoded block 132 to the selection block group.

In step S922, the encoded block 132 that has already been selected for use in the additional transmission data in the past in at least one of steps S921 and step S922 is included in the selection candidates. Further, when the encoded block 132 can be added to the additional transmission data, the encoded block 132 is added because it is more efficient to add the encoded block 132.

In (c) of Fig. 21, the encoded block 132 selected in step S922 is indicated by the underline. In the example illustrated in Fig. 21 (c), there is no encoded block 132 additionally selected in step S922 with regard to the additional transmission data #1 and #2. On the other hand, with regard to the additional transmission data #3, the encoded blocks 132 whose encoded block numbers are 1, 2, and 6 each have been further selected for use in the additional transmission data.

The block addition process with regard to the additional transmission data #3 in (c) of Fig. 21 will be described. Here, the data reception apparatus 200D whose terminal identifier is 4 is considered the subject apparatus, and the encoded block 132 whose encoded block number is 2 is considered the subject block. At the start point of step S922, only the encoded block 132 whose encoded block number is 7 is included in the selection block group. At this time, only the subject apparatus has not received the encoded block 132 included in the selection block group. On the other hand, the subject apparatus has received the subject block. Here, only the data reception apparatus 200D whose terminal identifier is 1 has not received the subject block, as at least one of the data reception apparatuses 200D other than the subject apparatus. Further, it is possible to decode the additional transmission data additionally encoded in all of the data reception apparatuses 200D even if the subject block is additionally encoded with regard to the additional transmission data #3 corresponding to the selection block group. Therefore, the additional transmission determination unit 112B selects the subject block for use in the additional transmission data with regard to the additional transmission data #3 corresponding to the selection block group. Further, the additional transmission determination unit 112B adds the subject block to the selection block group.

By executing the block addition process in the same way two more times, the additional transmission determination unit 112B selects the encoded block 132 corresponding to each of the encoded block numbers 1 and 6 for use in the additional transmission data.

When the process of step S922 is not executed, the additional transmission data #3 simply includes the data series whose encoded block number is 7. Therefore, compared to the case where step S922 is executed, the amount of information included in the additional transmission data #3 is less.

(Step S923)

The encoding processing unit 211D encodes the plurality of encoded blocks 132 selected in steps S921 and S922 by the Fountain Code, specifically the LT Code, and generates additional transmission data that includes data series indicating the encoded plurality of encoded blocks 132.

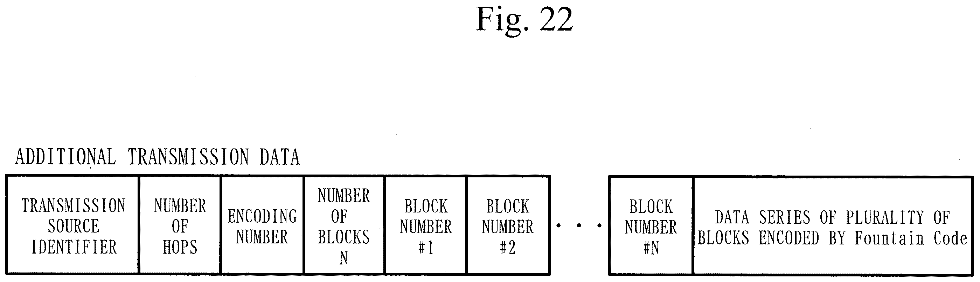

Fig. 22 illustrates an example of the format of the additional transmission data. The additional transmission data includes information indicating the plurality of encoded blocks 132. Therefore, the additional transmission data includes information indicating the number N of encoded blocks and N pieces of encoded block numbers, unlike the data during the initial transmission.

(Step S924)

The additional transmission determination unit 112B transmits from the transmission unit 121, the additional transmission data created in step S923 via the antenna 14, as a wireless signal.

The processes from steps S921 to S924 are repeated until each of all the encoded blocks 132 that has not been received by any of the data reception apparatuses 200D is included in any of the additional transmission data and transmitted.

(Step S925)

The additional transmission determination unit 112B determines whether or not each data reception apparatus 200D corresponding to the reception response indicating the decode failure in step S305 has transmitted all the encoded blocks 132 that have not been received. When there is an encoded block 132 that has not been transmitted, the data transmission apparatus 100B executes steps S921 to S924 again. When there is no encoded block 132 that has not been transmitted, that is, when each of all the encoded blocks 132 has been transmitted as any of the additional transmission data, the data transmission apparatus 100B returns to step S304 and receives the reception response from the surrounding data reception apparatus 200D.

*** Description of Effects of Embodiment 6 ***

In the present embodiment, as described above, encoding with regard to the additional transmission data uses the Fountain Code, especially the LT Code. This enables encoding and decoding by a relatively lightweight process that relies solely on an XOR operation. Further, according to the present embodiment, it is possible to improve the distribution efficiency as with Embodiments 1 to 3.

*** Other Embodiments ***

Each of the embodiments described above can be freely combined, or any component of each of the embodiments can be modified. Alternatively, any component can be omitted in each of the embodiments.

Alternatively, the embodiments are not limited to those presented in Embodiments 1 to 6, and various modifications can be made as needed. The procedures described using the flowcharts or the like may be modified as appropriate.

**Reference Signs List**

11, 21: processor; 12, 22: wireless module; 13, 23: storage device; 14, 24: antenna; 18: processing circuit; 90: content distribution system; 100, 100B: data transmission apparatus ; 111, 111B, 211 211D: encoding processing unit; 112, 112B, 212, 212D: additional transmission determination unit; 119, 219: initial transmission processing unit; 121, 221: transmission unit; 122, 222: reception unit; 130, 230: memory unit; 131: distribution data; 132: encoded block; 133: redundant data block; 134: number of hops of own terminal; 200, 200B, 200C, 200D: data reception apparatus; 213, 213D: decode processing unit; 214, 214B, 214C: reception response unit; 235: transmission source information; 236: destination information; 237: received electric power information.

**Claims**

1. A content distribution system comprising a plurality of content distribution apparatuses, each of which distributes content data via wireless communication, at a time when each content distribution apparatus of the plurality of content distribution apparatuses is a subject distribution apparatus, the subject distribution apparatus comprising:

   an encoding processing unit to divide subject content data, which is content data, into $K_1$ pieces of encoded blocks, and to generate M pieces of redundant data blocks by executing erasure correction coding on the $K_1$ pieces of encoded blocks;
   a transmission unit to transmit $K_2$ pieces of blocks selected from among the $K_1$ pieces of encoded blocks and the M pieces of redundant data blocks, together with a transmission source identifier, which is an apparatus identifier of the subject distribution apparatus, as wireless signals; and
   a reception unit to receive a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, wherein

the transmission unit of the subject distribution apparatus, when the destination identifier indicated in the reception response received by the subject distribution apparatus is consistent with the apparatus identifier of the subject distribution apparatus, transmits $K_2$-$R_{min}$ pieces of blocks selected from among blocks that have not been transmitted among the $K_1$ pieces of encoded blocks and the M pieces of redundant data blocks, as wireless signals, where the relatively small number of blocks among the number of blocks that have succeeded to be received as indicated in each reception response received by the subject distribution apparatus is denoted as $R_{min}$.

2. The content distribution system according to claim 1, wherein

the reception unit of the subject distribution apparatus receives a block from a content distribution apparatus other than the subject distribution apparatus,
the subject distribution apparatus further comprises
a decode processing unit to decode the content data as decode content data using the block received by the subject distribution apparatus, and
the encoding processing unit of the subject distribution apparatus uses the decode content data as the subject content data.

3. The content distribution system according to claim 1 or 2, wherein

the reception unit of the subject distribution apparatus receives a block from each content distribution apparatus other than the subject distribution apparatus,
the subject distribution apparatus further comprises
a memory unit to store transmission source information indicating a transmission source identifier corresponding to each block received by the subject distribution apparatus, and
the transmission unit of the subject distribution apparatus, after a reception response transmission timer has expired, transmits a reception response indicating a transmission source identifier corresponding to the relatively large number of receptions $R_n$ among the number of receptions $R_n$ of blocks received from each content distribution apparatus by the subject distribution apparatus among transmission source identifiers included in the transmission source information, via wireless communication, as a destination identifier.

4. The content distribution system according to claim 1 or 2, wherein

the reception unit of the subject distribution apparatus receives a block from each content distribution apparatus other than the subject distribution apparatus,
the subject distribution apparatus further comprises
a memory unit to store transmission source information indicating a transmission source identifier corresponding to each block received by the subject distribution apparatus, and destination information indicating a destination identifier indicated in each reception response received by the subject distribution apparatus, for each content distribution apparatus which is a transmission source of the reception response received by the subject distribution apparatus, and
the transmission unit of the subject distribution apparatus, after a reception response transmission timer has expired, transmits the reception response indicating a subject identifier which is an apparatus identifier selected from among transmission source identifiers corresponding to content distribution apparatuses whose number of receptions $R_n$ of blocks received from each content distribution apparatus by the subject distribution apparatus is greater than a threshold value $R_{th}$, among transmission source identifiers included in the transmission source information, and is an apparatus identifier set, by the relatively large number of content distribution apparatuses, as the destination identifier of each reception response received by the subject distribution apparatus among destination identifiers indicated in the destination information, as the destination identifier.

5. The content distribution system according to claim 4, wherein

the memory unit stores received electric power information indicating received electric power corresponding to each block received by the subject distribution apparatus, and
the subject identifier is an apparatus identifier selected from among transmission source identifiers whose received electric power corresponding to the corresponding block is equal to or greater than a threshold value $P_{th}$.

6. The content distribution system according to any one of claims 3 to 5, wherein

the subject distribution apparatus further comprises

a reception response unit, when the number of blocks indicated in the reception response received by the subject distribution apparatus as a subject reception response is less than the number of blocks received by the subject distribution apparatus, and when the destination identifier indicated in the subject reception response is consistent with any of transmission source identifiers corresponding to the blocks received by the subject distribution apparatus, to extend the reception response transmission timer.

7. The content distribution system according to any one of claims 1 to 6, wherein
the transmission unit of the subject distribution apparatus, during the time until the subject distribution apparatus receives a block that is transmitted at the last among blocks corresponding to second subject content data which is content data, or during the time until the subject distribution apparatus receives a new block which is a block corresponding to the second subject content data, is a block generated at a time point that differs from a time point at which the received block which is a block that has already been received by the subject distribution apparatus has been generated, and is a block generated by executing erasure correction coding on the second subject content data, transmits a reception response indicating the total number of blocks received by the subject distribution apparatus in place of the success or failure of reception for each block at the transmission sources and an identifier of each block received at the transmission sources, as a reception response corresponding to the second subject content data.

8. The content distribution system according to any one of claims 1 to 7, wherein
the $K_2$-$R_{min}$ pieces of blocks are $K_2$-$R_{min}$ pieces of blocks randomly selected from among blocks that have not been transmitted among the $K_1$ pieces of encoded blocks and the M pieces of redundant data blocks.

9. A content distribution method to be executed in a content distribution system comprising a plurality of content distribution apparatuses, each of which distributes content data via wireless communication,

each content distribution apparatus of the plurality of content distribution apparatuses being a computer,
at a time when each content distribution apparatus of the plurality of content distribution apparatuses is a subject distribution apparatus, the subject distribution apparatus comprising:

dividing subject content data, which is content data, into $K_1$ pieces of encoded blocks, and generating M pieces of redundant data blocks by executing erasure correction coding on the $K_1$ pieces of encoded blocks;
transmitting $K_2$ pieces of blocks selected from among the $K_1$ pieces of encoded blocks and the M pieces of redundant data blocks, together with a transmission source identifier, which is an apparatus identifier of the subject distribution apparatus, as wireless signals; and
receiving a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, and when the destination identifier indicated in the reception response received by the subject distribution apparatus is consistent with the apparatus identifier of the subject distribution apparatus, transmitting $K_2$-$R_{min}$ pieces of blocks selected from among blocks that have not been transmitted among the $K_1$ pieces of encoded blocks and the M pieces of redundant data blocks, as wireless signals, where the relatively small number of blocks among the number of blocks that have succeeded to be received as indicated in each reception response received by the subject distribution apparatus is denoted as $R_{min}$.

10. A content distribution program to be executed in a content distribution system comprising a plurality of content distribution apparatuses, each of which distributes content data via wireless communication,

each content distribution apparatus of the plurality of content distribution apparatuses being a computer,
at a time when each content distribution apparatus of the plurality of content distribution apparatuses is a subject distribution apparatus, the content distribution program for causing the subject distribution apparatus to execute:

an encoding processing process to divide subject content data, which is content data, into $K_1$ pieces of encoded blocks, and to generate M pieces of redundant data blocks by executing erasure correction coding on the $K_1$ pieces of encoded blocks;

a transmission process to transmit $K_2$ pieces of blocks selected from among the $K_1$ pieces of encoded blocks and the M pieces of redundant data blocks, together with a transmission source identifier, which is an apparatus identifier of the subject distribution apparatus, as wireless signals; and

a reception process to receive a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, wherein

during the transmission process, when the destination identifier indicated in the reception response received by the subject distribution apparatus is consistent with the apparatus identifier of the subject distribution apparatus, $K_2$-$R_{min}$ pieces of blocks selected from among blocks that have not been transmitted among the $K_1$ pieces of encoded blocks and the M pieces of redundant data blocks are transmitted, as wireless signals, where the relatively small number of blocks among the number of blocks that have succeeded to be received as indicated in each reception response received by the subject distribution apparatus is denoted as $R_{min}$.

11. A content distribution system comprising a plurality of content distribution apparatuses, each of which distributes content data via wireless communication, at a time when each content distribution apparatus of the plurality of content distribution apparatuses is a subject distribution apparatus, the subject distribution apparatus comprising:

an encoding processing unit to divide subject content data, which is content data, into $K_1$ pieces of encoded blocks;

a transmission unit to transmit the $K_1$ pieces of encoded blocks, together with a transmission source identifier, which is an apparatus identifier of the subject distribution apparatus, as wireless signals; and

a reception unit to receive a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, wherein

the encoding processing unit of the subject distribution apparatus, when the destination identifier indicated in each reception response received by the subject distribution apparatus is consistent with the apparatus identifier of the subject distribution apparatus, encodes a plurality of blocks selected from among blocks that have failed to be received as indicated in each reception response received by the subject distribution apparatus, by a Fountain Code, and creates additional transmission data indicating the encoded plurality of blocks,

the transmission unit of the subject distribution apparatus transmits the created additional transmission data as a wireless signal,

the reception unit of the subject distribution apparatus receives additional transmission data from another content distribution apparatus, as a wireless signal, and

the subject distribution apparatus further comprises:

an additional transmission determination unit, when the destination identifier indicated in each reception response received by the subject distribution apparatus is consistent with the apparatus identifier of the subject distribution apparatus, to select a plurality of blocks from among blocks that have failed to be received as indicated in each reception response received by the subject distribution apparatus, as the plurality of blocks, so that the created additional transmission data can be decoded in any of content distribution apparatuses that have failed to receive one or more blocks among content distribution apparatuses corresponding to each reception response received by the subject distribution apparatus, based on the success or failure of reception of each block indicated in each reception response received by the subject distribution apparatus; and

a decode processing unit to restore a plurality of blocks corresponding to the received additional transmission data by decoding the encoded plurality of blocks indicated in the additional transmission data received from the other content distribution apparatus by the Fountain Code.

12. The content distribution system according to claim 11, wherein

the reception unit of the subject distribution apparatus receives a block from each content distribution apparatus other than the subject distribution apparatus,
the subject distribution apparatus further comprises
a memory unit to store transmission source information indicating a transmission source identifier corresponding to each block received by the subject distribution apparatus, and
the transmission unit of the subject distribution apparatus, after a reception response transmission timer has expired, transmits a reception response indicating a transmission source identifier corresponding to the relatively large number of receptions $R_n$ among the number of receptions $R_n$ of blocks received from each content distribution apparatus by the subject distribution apparatus among transmission source identifiers included in the transmission source information, via wireless communication, as a destination identifier.

13. The content distribution system according to claim 11 or 12, wherein

the reception unit of the subject distribution apparatus receives a block from each content distribution apparatus other than the subject distribution apparatus,
the subject distribution apparatus further comprises
a memory unit to store transmission source information indicating a transmission source identifier corresponding to each block received by the subject distribution apparatus, and destination information indicating a destination identifier indicated in each reception response received by the subject distribution apparatus, for each content distribution apparatus which is a transmission source of the reception response received by the subject distribution apparatus, and
the transmission unit of the subject distribution apparatus, after a reception response transmission timer has expired, transmits the reception response indicating a subject identifier which is an apparatus identifier selected from among the transmission source identifiers corresponding to content distribution apparatuses whose number

of receptions $R_n$ of blocks received from each content distribution apparatus by the subject distribution apparatus is greater than a threshold value $R_{th}$ among transmission source identifiers included in the transmission source information, and is an apparatus identifier set, by the relatively large number of content distribution apparatuses, as the destination identifier of each reception response received by the subject distribution apparatus among destination identifiers indicated in the destination information, as the destination identifier.

14. The content distribution system according to claim 13, wherein

the memory unit stores received electric power information indicating received electric power corresponding to each block received by the subject distribution apparatus, and
the subject identifier is an apparatus identifier selected from among transmission source identifiers whose received electric power corresponding to the corresponding block is equal to or greater than a threshold value $P_{th}$.

15. The content distribution system according to any one of claims 12 to 14, wherein

the subject distribution apparatus further comprises
a reception response unit, when the number of blocks indicated in the reception response received by the subject distribution apparatus as a subject reception response is less than the number of blocks received by the subject distribution apparatus, and when the destination identifier indicated in the subject reception response is consistent with any of transmission source identifiers corresponding to the blocks received by the subject distribution apparatus, to extend the reception response transmission timer.

16. The content distribution system according to any one of claims 11 to 15, wherein
the transmission unit of the subject distribution apparatus, during the time until the subject distribution apparatus receives a block that is transmitted at the last among blocks corresponding to second subject content data which is content data, or during the time until the subject distribution apparatus receives a new block which is a block corresponding to the second subject content data, is a block generated at a time point that differs from a time point at which the received block which is a block that has already been received by the subject distribution apparatus has been generated, and is a block generated by executing erasure correction coding on the second subject content data, transmits a reception response indicating the total number of blocks received by the subject distribution apparatus in place of the success or failure of reception for each block at the transmission sources and an identifier of each block received at the transmission sources, as a reception response corresponding to the second subject content data.

17. A content distribution method to be executed in a content distribution system comprising a plurality of content distribution apparatuses, each of which distributes content data via wireless communication,

each content distribution apparatus of the plurality of content distribution apparatuses being a computer,

at a time when each content distribution apparatus of the plurality of content distribution apparatuses is a subject distribution apparatus, the subject distribution apparatus comprising:

dividing subject content data, which is content data, into $K_1$ pieces of encoded blocks; transmitting the $K_1$ pieces of encoded blocks, together with a transmission source identifier, which is an apparatus identifier of the subject distribution apparatus, as wireless signals;

receiving a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources;

when the destination identifier indicated in each reception response received by the subject distribution apparatus is consistent with the apparatus identifier of the subject distribution apparatus, encoding a plurality of blocks selected from among blocks that have failed to be received as indicated in each reception response received by the subject distribution apparatus, by a Fountain Code, and creating additional transmission data indicating the encoded plurality of blocks;

transmitting the created additional transmission data as a wireless signal;

receiving additional transmission data from another content distribution apparatus, as a wireless signal;

when the destination identifier indicated in each reception response received by the subject distribution apparatus is consistent with the apparatus identifier of the subject distribution apparatus, selecting a plurality of blocks from among blocks that have failed to be received as indicated in each reception response received by the subject distribution apparatus, as the plurality of blocks, so that the created additional transmission data can be decoded in any of content distribution apparatuses that have failed to receive one or more blocks among content distribution apparatuses corresponding to each reception response received by the subject distribution apparatus, based on the success or failure of reception of each block indicated in each reception response received by the subject distribution apparatus; and

restoring a plurality of blocks corresponding to the received additional transmission data by decoding the encoded plurality of blocks indicated in the additional transmission data received from the other content distribution apparatus by the Fountain Code.

18. A content distribution program to be executed in a content distribution system comprising a plurality of content distribution apparatuses, each of which distributes content data via wireless communication,

each content distribution apparatus of the plurality of content distribution apparatuses being a computer,

at a time when each content distribution apparatus of the plurality of content distribution apparatuses is a subject distribution apparatus, the content distribution program for causing the subject distribution apparatus to execute:

an encoding process to divide subject content data, which is content data, into $K_1$ pieces of encoded blocks;

a transmission process to transmit the $K_1$ pieces of encoded blocks, together with a transmission source identifier, which is an apparatus identifier of the subject distribution apparatus, as wireless signals; and

a reception process to receive a reception response, which is information transmitted by each content distribution apparatus of two or more content distribution apparatuses other than the subject distribution apparatus, and is information indicating each of transmission source identifiers indicating the content distribution apparatuses which are transmission sources, a destination identifier indicating a content distribution apparatus which is a destination, the success or failure of reception for each block at the transmission sources, and an identifier of each block received at the transmission sources, wherein

during the encoding process, when the destination identifier indicated in each reception response received by the subject distribution apparatus is consistent with the apparatus identifier of the subject distribution apparatus, a plurality of blocks selected from among blocks that have failed to be received as indicated in each reception response received by the subject distribution apparatus, are encoded by a Fountain Code, and additional transmission data indicating the encoded plurality of blocks is created,

during the transmission process, the created additional transmission data is transmitted as a wireless signal,

during the reception process, additional transmission data is received from another content distribution apparatus, as a wireless signal, and

the content distribution program causes the subject distribution apparatus to execute:

an additional transmission determination process, when the destination identifier indicated in each reception response received by the subject distribution apparatus is consistent with the apparatus identifier of the subject distribution apparatus, to select a plurality of blocks from among blocks that have failed to be received as indicated in each reception response received by the subject distribution apparatus, as the plurality of blocks, so that the created additional transmission data can be decoded in any of content distribution apparatuses that have failed to receive one or more blocks among content distribution apparatuses corresponding to each reception response received by the subject distribution apparatus, based on the success or failure of reception of each block indicated in each reception response received by the subject distribution apparatus; and a decode processing process to restore a plurality of blocks corresponding to the received additional transmission data by decoding the encoded plurality of blocks indicated in the additional transmission data received from the other content distribution apparatus by the Fountain Code.

# Fig. 1

# Fig. 2

# Fig. 3

DATA RECEPTION APPARATUS 200

24

WIRELESS MODULE 22

TRANSMISSION UNIT 221

RECEPTION UNIT 222

PROCESSOR 21

ADDITIONAL TRANSMISSION DETERMINATION UNIT 212

ENCODING PROCESSING UNIT 211

RECEPTION RESPONSE UNIT 214

DECODE PROCESSING UNIT 213

STORAGE DEVICE 23

MEMORY UNIT 230

DISTRIBUTION DATA 131

ENCODED BLOCK 132

REDUNDANT DATA BLOCK 133

NUMBER OF HOPS OF OWN TERMINAL 134

TRANSMISSION SOURCE INFORMATION 235

EP 4 683 257 A1

Fig. 4

EP 4 683 257 A1

START

GENERATE ENCODED BLOCK AND
REDUNDANT DATA BLOCK — S301

STORE ENCODED BLOCK AND
REDUNDANT DATA BLOCK — S302

TRANSMIT $K_2$ PIECES OF BLOCKS
AS WIRELESS SIGNALS — S303

OBTAIN RECEPTION RESPONSE — S304

DO ALL RECEPTION
RESPONSES INDICATE
DECODE SUCCESS? — S305

OBTAIN MINIMUM VALUE $R_{min}$ OF
NUMBER OF RECEIVED BLOCKS AND
NUMBER OF UNRECEIVED BLOCK — S306

IS NUMBER OF
UNTRANSMITTED BLOCKS
EQUAL TO OR GREATER THAN
$K_2 - R_{min}$? — S307

NO

TRANSMIT ALL UNTRANSMITTED BLOCKS
AS WIRELESS SIGNALS — S309

YES

TRANSMIT $K_2 - R_{min}$ PIECES OF
UNTRANSMUTED BLOCKS
AS WIRELESS SIGNALS — S308

TRANSMIT $K_2 - R_n - T$ PIECES OF
BLOCKS AS WIRELESS SIGNALS — S310

NO

YES

END

## Fig. 5

ENCODED BLOCK /
REDUNDANT DATA BLOCK

| TRANSMISSION SOURCE IDENTIFIER | NUMBER OF HOPS | ENCODING NUMBER | BLOCK NUMBER | DATA SERIES OF ENCODED BLOCK/ REDUNDANT DATA BLOCK |
|---|---|---|---|---|

# Fig. 6

EP 4 683 257 A1

| DECODE FAILURE | TRANSMISSION SOURCE IDENTIFIER | DESTINATION IDENTIFIER | ENCODING NUMBER | DECODE STATUS | RECEPTION BLOCK BITMAP 1: RECEIVED, 0: NOT RECEIVED |
|---|---|---|---|---|---|

$(K + M)/8$ Byte

| DECODE SUCCESS | TRANSMISSION SOURCE IDENTIFIER | DESTINATION IDENTIFIER | ENCODING NUMBER | DECODE STATUS |
|---|---|---|---|---|

# Fig. 7

TRANSMIT RECEIPT RESPONSE INDICATING DECODE FAILURE AS WIRELESS SIGNAL

S612 RECEPTION RESPONSE TRANSMISSION TIMER HAS EXPIRED

START

A

D

HAS WIRELESS SIGNAL BEEN RECEIVED OR HAS RECEPTION RESPONSE TRANSMISSION TIMER EXPIRED? — S601

WIRELESS SIGNAL HAS BEEN RECEIVED

HAS TYPE OF RECEIVED SIGNAL DETERMINED? — S602

RECEPTION RESPONSE

BLOCK

UPDATE NUMBER OF HOPS OF OWN TERMINAL ACCORDING TO NUMBER OF HOPS INDICATED IN RECEIVED SIGNAL — S603

STORE TRANSMISSION SOURCE IDENTIFIER AND NUMBER OF HOPS INDICATED IN RECEIVED SIGNAL — S604

APPROPRIATELY STORE BLOCK INDICATED IN RECEIVED SIGNAL — S605

DOES RECEPTION RESPONSE INDICATE DECODE FAILURE AND IS NUMBER OF RECEIVED BLOCKS LESS THAN PREDETERMINED VALUE? — S613

NO

YES

B

C

EP 4 683 257 A1

# Fig. 8

(A) (B) (C) (D)

**S606** START RECEPTION RESPONSE TRANSMISSION TIMER

**S607** IS NEW BLOCK STORED AND IS DECODE PROCESS POSSIBLE?
- NO → (A)
- YES

**S608** EXECUTE DECODE PROCESS

**S609** DECODE SUCCESS OR DECODE FAILURE?
- DECODE FAILURE → (A)
- DECODE SUCCESS

**S610** TRANSMIT RECEPTION RESPONSE INDICATING DECODE SUCCESS AS WIRELESS SIGNAL

**S611** EXECUTE SAME PROCESSING OF DATA TRANSMISSION APPARATUS

END

**S614** IS DESTINATION IDENTIFIER INDICATED IN RECEPTION RESPONSE CONSISTENT WITH TRANSMISSION SOURCE IDENTIFIER?
- NO → (D)
- YES

**S615** EXTEND EXPIRATION TIME OF RECEPTION RESPONSE TRANSMISSION TIMER → (D)

EP 4 683 257 A1

# Fig. 9

EP 4 683 257 A1

# Fig. 10

# Fig. 11

START

E →

H

**S612B** TRANSMIT RECEPTION RESPONSE INDICATING DECODE FAILURE AS WIRELESS SIGNAL. SET TRANSMISSION SOURCE IDENTIFIER CORRESPONDING TO LARGEST NUMBER OF RECEPTIONS AS DESTINATION IDENTIFIER.

RECEPTION RESPONSE TRANSMISSION TIMER HAS EXPIRED

**S601** HAS WIRELESS SIGNAL BEEN RECEIVED OR HAS RECEPTION RESPONSE TRANSMISSION TIMER EXPIRED?

WIRELESS SIGNAL HAS BEEN RECEIVED

**S602** HAS TYPE OF RECEIVED SIGNAL DETERMINED?

RECEPTION RESPONSE

**S801** SAVE DESTINATION IDENTIFIER

BLOCK

**S603** UPDATE NUMBER OF HOPS OF OWN TERMINAL ACCORDING TO NUMBER OF HOPS INDICATED IN RECEIVED SIGNAL

**S604** STORE TRANSMISSION SOURCE IDENTIFIER AND NUMBER OF HOPS INDICATED IN RECEIVED SIGNAL

**S605** APPROPRIATELY STORE BLOCK INDICATED IN RECEIVED SIGNAL

F

**S613** DOES RECEPTION RESPONSE INDICATE DECODE FAILURE AND IS NUMBER OF RECEIVED BLOCKS LESS THAN PREDETERMINED VALUE?

NO

YES

G

EP 4 683 257 A1

# Fig. 12

EP 4 683 257 A1

# Fig. 13

EP 4 683 257 A1

# Fig. 14

EP 4 683 257 A1

Flowchart:

**START**

**(I)** →

**S601** HAS WIRELESS SIGNAL BEEN RECEIVED OR HAS RECEPTION RESPONSE TRANSMISSION TIMER EXPIRED?

→ WIRELESS SIGNAL HAS BEEN RECEIVED

**S602** HAS TYPE OF RECEIVED SIGNAL DETERMINED? → RECEPTION RESPONSE → **S801** SAVE DESTINATION IDENTIFIER

BLOCK ↓

**S901** STORE RECEIVED ELECTRIC POWER OF RECEIVED BLOCK FOR EACH TRANSMISSION SOURCE IDENTIFIER

**S603** UPDATE NUMBER OF HOPS OF OWN TERMINAL ACCORDING TO NUMBER OF HOPS INDICATED IN RECEIVED SIGNAL

**S604** STORE TRANSMISSION SOURCE IDENTIFIER AND NUMBER OF HOPS INDICATED IN RECEIVED SIGNAL

**S605** APPROPRIATELY STORE BLOCK INDICATED IN RECEIVED SIGNAL

→ **(J)**

**S613** DOES RECEPTION RESPONSE INDICATE DECODE FAILURE AND IS NUMBER OF RECEIVED BLOCKS LESS THAN PREDETERMINED VALUE? → NO → **(L)**

↓ → **(K)**

**S612C** RECEPTION RESPONSE TRANSMISSION TIMER HAS EXPIRED

TRANSMIT RECEPTION RESPONSE INDICATING DECODE FAILURE AS WIRELESS SIGNAL. SET APPARATUS IDENTIFIER WHOSE NUMBER OF RECEPTIONS AMONG RECEPTION RESPONSES IS EQUAL TO OR GREATER THAN THRESHOLD VALUE AND RECEIVED ELECTRIC POWER IS EQUAL TO OR GREATER THAN THRESHOLD VALUE, AS DESTINATION IDENTIFIER.

39

# Fig. 15

(J) → **S606** START RECEPTION RESPONSE TRANSMISSION TIMER

**S607** IS NEW BLOCK STORED AND IS DECODE PROCESS POSSIBLE?
- NO → (I)
- YES ↓

**S608** EXECUTE DECODE PROCESS

**S609** DECODE SUCCESS OR DECODE FAILURE?
- DECODE FAILURE → (I)
- DECODE SUCCESS ↓

**S610** TRANSMIT RECEPTION RESPONSE INDICATING DECODE SUCCESS AS WIRELESS SIGNAL

**S611** EXECUTE SAME PROCESSING OF DATA TRANSMISSION APPARATUS

END

(K) → **S614** IS DESTINATION IDENTIFIER INDICATED IN RECEPTION RESPONSE CONSISTENT WITH TRANSMISSION SOURCE IDENTIFIER?
- NO → (L)
- YES ↓

**S615** EXTEND EXPIRATION TIME OF RECEPTION RESPONSE TRANSMISSION TIMER → (L)

## Fig. 16

DECODE FAILURE

| TRANSMISSION SOURCE IDENTIFIER | DESTINATION IDENTIFIER | ENCODING NUMBER | DECODE STATUS | NUMBER OF RECEIVED BLOCKS |
|---|---|---|---|---|

41

# Fig. 17

START

S301 — GENERATE ENCODED BLOCK AND REDUNDANT DATA BLOCK

S302 — STORE ENCODED BLOCK AND REDUNDANT DATA BLOCK

S303 — TRANSMIT $K_2$ PIECES OF BLOCKS AS WIRELESS SIGNALS

S304 — OBTAIN RECEPTION RESPONSE

S305 — DO ALL RECEPTION RESPONSES INDICATE DECODE SUCCESS? — NO

YES

END

S306 — OBTAIN MINIMUM VALUE $R_{min}$ OF NUMBER OF RECEIVED BLOCKS AND NUMBER OF UNRECEIVED BLOCK

S307 — IS NUMBER OF UNRECEIVED BLOCKS EQUAL TO OR GREATER THAN $K_2 - R_{min}$? — NO

YES

S309 — TRANSMIT ALL UNTRANSMITTED BLOCKS AS WIRELESS SIGNALS

S308B — TRANSMIT RANDOM UNTRANSMITTED $K_2 - R_{min}$ PIECES OF BLOCKS AS WIRELESS SIGNALS

S310B — RANDOMLY SELECT FROM BLOCKS WITH RELATIVELY LARGE NUMBER OF DATA RECEPTION APPARATUSES THAT HAVE NOT RECEIVED $K_2 - R_n - T$ PIECES OF BLOCKS AND TRANSMIT AS WIRELESS SIGNALS

# Fig. 18

DATA RECEPTION APPARATUS 100B

WIRELESS MODULE 12

TRANSMISSION UNIT 121

RECEPTION UNIT 122

PROCESSOR 11

STORAGE DEVICE 13

INITIAL TRANSMISSION PROCESSING UNIT 119

MEMORY UNIT 130

DISTRIBUTION DATA 131

NUMBER OF HOPS OF OWN TERMINAL 134

ADDITIONAL TRANSMISSION DETERMINATION UNIT 112B

ENCODING PROCESSING UNIT 111B

ENCODED BLOCK 132

ANTENNA 14

# Fig. 19

# Fig. 20

START

GENERATE ENCODED BLOCK — S301B

STORE ENCODED BLOCK — S302B

TRANSMIT ALL ENCODED BLOCKS — S303B

OBTAIN RECEPTION RESPONSE — S304

DO ALL RECEPTION RESPONSES INDICATE DECODE SUCCESS? — S305

NO →

YES

END

OBTAIN NUMBER OF UNRECEIVED BLOCK OF EACH DATA RECEPTION APPARATUS — S306B

SELECT UNRECEIVED BLOCK THAT CAN BE DECODED USING INFORMATION ON BLOCK THAT HAS ALREADY BEEN RECEIVED BY EACH DATA RECEPTION APPARATUS — S921

SELECT UNRECEIVED BLOCK THAT DOES NOT AFFECT DECODE EVEN IF BEING ADDED TO BLOCK SELECTED IN S921 — S922

ENCODE BLOCKS SELECTED IN S921 AND S922 USING Fountain Code AND CREATE ADDITIONAL TRANSMISSION DATA — S923

TRANSMIT ADDITIONAL TRANSMISSION DATA ENCODED BY Fountain Code AS WIRELESS SIGNAL — S924

HAS ALL UNRECEIVED BLOCKS TRANSMITTED? — S925

NO

YES

EP 4 683 257 A1

# Fig. 21

DATA RECEPTION APPARATUS TERMINAL IDENTIFIER ↓

ENCODED BLOCK NUMBER →

1: RECEPTION
0: NON-RECEPTION

| | 1 | 2 | 3 | 4 | 5 | 6 | 7 |
|---|---|---|---|---|---|---|---|
| 1 | 1 | 0 | 1 | 1 | 0 | 1 | 1 |
| 2 | 1 | 1 | 0 | 1 | 1 | 0 | 1 |
| 3 | 0 | 1 | 1 | 0 | 1 | 1 | 1 |
| 4 | 1 | 1 | 0 | 1 | 0 | 1 | 0 |

(a) RECEPTION STATUS OF ENCODED BLOCK

ADDITIONAL TRANSMISSION DATA ↓

ENCODED BLOCK NUMBER →

| | 1 | 2 | 3 | 4 | 5 | 6 | 7 |
|---|---|---|---|---|---|---|---|
| #1 | 1 | 1 | 1 | 0 | 0 | 0 | 0 |
| #2 | 0 | 0 | 0 | 1 | 1 | 1 | 0 |
| #3 | 0 | 0 | 0 | 0 | 0 | 0 | 1 |

(b) ENCODED BLOCK SELECTED IN STEP S921

ADDITIONAL TRANSMISSION DATA ↓

ENCODED BLOCK NUMBER →

1: ENCODED BLOCK INCLUDED IN ADDITIONAL TRANSMISSION DATA
0: ENCODED BLOCK NOT INCLUDED IN ADDITIONAL TRANSMISSION DATA

| | 1 | 2 | 3 | 4 | 5 | 6 | 7 |
|---|---|---|---|---|---|---|---|
| #1 | 1 | 1 | 1 | 0 | 0 | 0 | 0 |
| #2 | 0 | 0 | 0 | 1 | 1 | 1 | 0 |
| #3 | 1 | 1 | 0 | 0 | 0 | 1 | 1 |

(c) ENCODED BLOCK SELECTED IN STEP S922

EP 4 683 257 A1

# Fig. 22

EP 4 683 257 A1

ADDITIONAL TRANSMISSION DATA

| TRANSMISSION SOURCE IDENTIFIER | NUMBER OF HOPS | ENCODING NUMBER | NUMBER OF BLOCKS N | BLOCK NUMBER #1 | BLOCK NUMBER #2 | · · · | BLOCK NUMBER #N | DATA SERIES OF PLURALITY OF BLOCKS ENCODED BY Fountain Code |

## INTERNATIONAL SEARCH REPORT

| International application No. |
| --- |
| **PCT/JP2024/000112** |

| A. | CLASSIFICATION OF SUBJECT MATTER |
| --- | --- |

*H04L 1/1825*(2023.01)i; *H03M 13/37*(2006.01)i; *H04L 1/00*(2006.01)i; *H04L 1/1607*(2023.01)i; *H04W 52/46*(2009.01)i
FI:  H04L1/1825; H03M13/37; H04L1/00 B; H04L1/1607; H04W52/46

According to International Patent Classification (IPC) or to both national classification and IPC

| B. | FIELDS SEARCHED |
| --- | --- |

Minimum documentation searched (classification system followed by classification symbols)

H04L1/1825; H03M13/37; H04L1/00; H04L1/1607; H04W52/46

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

IEEE Xplore

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | JP 2007-166469 A (KDDI CORPORATION) 28 June 2007 (2007-06-28) <br> paragraphs [0027]-[0032], [0037], [0043]-[0046], fig. 1-2 | 1-18 |
| A | JP 2016-146620 A (NIPPON TELEGRAPH AND TELEPHONE CORPORATION) 12 August 2016 (2016-08-12) <br> paragraphs [0023]-[0050], [0083]-[0086], fig. 1-2 | 1-18 |
| A | JP 2016-27698 A (NIPPON TELEGRAPH AND TELEPHONE CORPORATION) 18 February 2016 (2016-02-18) <br> paragraphs [0021]-[0054], [0082]-[0086], fig. 1-2 | 1-18 |
| A | 角 武憲，他, 消失訂正符号を用いた高効率ファームウェア配信方式の検討, 情報処理学会第８４回全国大会講演論文集, 17 February 2022, vol. 84, no. 3, pp. 3.29-3.30, non-official translation (SUMI, Takenori et al. Research on efficient firmware distribution method using erasure correction code. Lecture proceedings of the 84th National Convention of IPSJ.) in particular, sections 1-3 | 1-18 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **19 February 2024** | **27 February 2024** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (July 2022)

## INTERNATIONAL SEARCH REPORT

| International application No. |
| --- |
| **PCT/JP2024/000112** |

### C. DOCUMENTS CONSIDERED TO BE RELEVANT

| Category* | Citation of document, with indication, where appropriate, of the relevant passages | Relevant to claim No. |
| --- | --- | --- |
| A | JP 2015-100109 A (SAMSUNG ELECTRONICS CO., LTD.) 28 May 2015 (2015-05-28) paragraphs [0113]-[0165], fig. 8 | 1-18 |
| A | US 2020/0120459 A1 (QUALCOMM INCORPORATED) 16 April 2020 (2020-04-16) paragraph [0066], fig. 5 | 11-18 |
| A | CN 102833051 A (BEIJING INSTITUTE OF TECHNOLOGY) 19 December 2012 (2012-12-19) paragraph [0044] | 11-18 |
| A | JP 4-362819 A (EISEI TSUSHIN SYST GIJUTSU KENKYUSHO KK) 15 December 1992 (1992-12-15) paragraphs [0016]-[0023], fig. 1 | 11-18 |
| A | 小野 真穂, 他, 光パケット交換ネットワークにおけるErasure-codingと確認応答を組み合わせたデータ転送方式の提案, 電子情報通信学会技術研究報告 [online], 02 September 2022, vol. 122, no. 170, pp. 55-59, Internet<URL:https://www.ieice.org/publications/search/summary.php?id=120385&tbl=ken&lang=jp>, (ONO, Maho et al. A Proposal of Data Transfer Method Combining Erasure-coding and Acknowledgement Feedback in Optical Packet Switching Networks. IEICE Technical Report.) in particular, sections 2-3 | 11-18 |
| A | 久野 和英, 他, サポート配信機能を有するメタコンテンツのマルチキャスト配信制御, 電子情報通信学会技術研究報告, 12 December 2003, vol. 103, no. 506, pp. 13-16, (KUNO, Kazuhide et al. Multicast Meta-Contents Delivery Method with Support Server Function. IEICE Technical Report.) in particular, sections 2-3 | 11-18 |

Form PCT/ISA/210 (second sheet) (July 2022)

## INTERNATIONAL SEARCH REPORT
### Information on patent family members

International application No.

**PCT/JP2024/000112**

| Patent document cited in search report | | | Publication date (day/month/year) | Patent family member(s) | | | Publication date (day/month/year) |
|---|---|---|---|---|---|---|---|
| JP | 2007-166469 | A | 28 June 2007 | (Family: none) | | | |
| JP | 2016-146620 | A | 12 August 2016 | (Family: none) | | | |
| JP | 2016-27698 | A | 18 February 2016 | (Family: none) | | | |
| JP | 2015-100109 | A | 28 May 2015 | US paragraphs [0161]-[0239], fig. 8 | 2015/0139227 | A1 | |
| | | | | EP | 2876832 | A2 | |
| | | | | KR | 10-2015-0057347 | A | |
| | | | | CN | 104660381 | A | |
| US | 2020/0120459 | A1 | 16 April 2020 | WO | 2020/076414 | A1 | |
| | | | | CN | 112806033 | A | |
| CN | 102833051 | A | 19 December 2012 | (Family: none) | | | |
| JP | 4-362819 | A | 15 December 1992 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6556415 B

**Non-patent literature cited in the description**

- **W. MATSUMOTO et al.** Rate-Compatible QC-LDPC codes. *SITA2006*, 28 November 2006